# EUROPEAN PATENT APPLICATION

(11) **EP 4 436 345 A2**
(43) Date of publication of application: **25.09.2024**
(21) Application number: 24165624.8
(22) Date of filing: 22.03.2024
(51) Int. Cl.: H10K 59/131, G09G 3/3233

(54) **DISPLAY PANEL AND VEHICLE INCLUDING THE DISPLAY PANEL**

(30) Priority: 24.03.2023 KR 20230039253; 27.03.2023 KR 20230039915
(71) Applicant: Samsung Display Co., Ltd., Yongin-si, Gyeonggi-do 17113 (KR)
(72) Inventor: Choi, Junwon, 17113 Yongin-si (KR); Seo, Myeonghee, 17113 Yongin-si (KR); Song, Hwayoung, 17113 Yongin-si (KR); Min, Junyoung, 17113 Yongin-si (KR)
(74) Representative: Taor, Simon Edward William

(57) **Abstract**

A display panel includes a substrate including a display area including a sub-pixel and a non-display area outside the display area, the non-display area including a pad area, a demultiplexer circuit area which is disposed in the non-display area and transmits a data signal to the sub-pixel, a compensation capacitor area between the pad area and the demultiplexer circuit area, the compensation capacitor area including a plurality of compensation capacitors each including a first electrode and a second electrode on the first electrode, and a plurality of fan-out lines extending from the pad area to the compensation capacitor area.

## Description

This application claims priority to Korean Patent Application No. 10-2023-0039253, filed on March 24, 2023, and Korean Patent Application No. 10-2023-0039915, filed on March 27, 2023, and all the benefits accruing therefrom.

### BACKGROUND

### 1. Field

Embodiments relate to a display panel and a vehicle including the display panel.

### 2. Description of the Related Art

Recently, the usage of display apparatuses is being diversified. Also, display apparatuses are becoming thinner and more lightweight, and thus, the use thereof is being expanded. As display apparatuses are used in various fields, the demand for display apparatuses that provide high-quality images is increasing. Recently, display apparatuses are being disposed inside a vehicle in order to provide an image to a user sitting in a driver seat or a passenger seat.

In addition, a shape of display apparatuses is being diversified. The display apparatuses may have a circular shape, a polygonal shape, and the like, for example. Display apparatuses may also have a shape in which each vertex of a polygon has curvature.

### SUMMARY

Embodiments include a display panel with improved display quality and reliability and a vehicle including the display panel. However, this is only an example, and the scope of the disclosure is not limited thereby.

Additional features will be set forth in part in the description which follows and, in part, will be apparent from the description, or may be learned by practice of the presented embodiments of the disclosure.

In an embodiment of the disclosure, a display panel includes a substrate including a display area including a sub-pixel and a non-display area outside the display area, the non-display area including a pad area, a demultiplexer circuit area which is disposed in the non-display area and transmits a data signal to the sub-pixel, a compensation capacitor area between the pad area and the demultiplexer circuit area, the compensation capacitor area including a plurality of compensation capacitors each including a first electrode and a second electrode on the first electrode, and a plurality of fan-out lines extending from the pad area to the compensation capacitor area.

In an embodiment, the first electrode may be electrically connected to one of the plurality of fan-out lines, and the second electrode may be electrically connected to a power supply line.

In an embodiment, the plurality of fan-out lines may be arranged in a direction away from a central portion of the pad area and may include a first fan-out line and a second fan-out line in a same layer, and a length of the second fan-out line may be greater than a length of the first fan-out line.

In an embodiment, the plurality of compensation capacitors may include a first compensation capacitor electrically connected to the first fan-out line and a second compensation capacitor electrically connected to the second fan-out line, and a capacitance of the first compensation capacitor may be greater than a capacitance of the second compensation capacitor.

In an embodiment, an area of the first electrode of the first compensation capacitor may be greater than an area of the first electrode of the second compensation capacitor, and an area of the second electrode of the first compensation capacitor may be greater than an area of the second electrode of the second compensation capacitor.

In an embodiment, the display panel may further include a light-emitting element in the display area, a first transistor between the substrate and the light-emitting element, and a storage capacitor electrically connected to the first transistor, where the first transistor may include a first semiconductor layer and a first gate electrode overlapping a channel region of the first semiconductor layer, and the storage capacitor may include a first capacitor electrode in a same layer as the first gate electrode and a second capacitor electrode on the first capacitor electrode.

In an embodiment, the first electrode may include a same material as a material of the first gate electrode, and the second electrode may include a same material as a material of the second capacitor electrode.

In an embodiment, the display panel may further include a second transistor on the substrate, and a bottom metal layer below the first semiconductor layer, where the second transistor may include a second semiconductor layer including an oxide semiconductor, and a second gate electrode on the second semiconductor layer and overlapping a channel region of the second semiconductor layer.

In an embodiment, the first electrode may include a same material as a material of the bottom metal layer, and the second electrode may include a same material as a material of the first gate electrode.

In an embodiment, the first electrode may include a same material as a material of the second capacitor electrode, and the second electrode may include a same material as a material of the second gate electrode.

In an embodiment, the plurality of compensation capacitors may each further include a third electrode on the second electrode and electrically connected to the first electrode, the first electrode may include a same material as a material of the first gate electrode, the second electrode may include a same material as a material of the second capacitor electrode, and the third electrode may include a same material as a material of the second gate electrode.

In an embodiment of the disclosure, a vehicle includes a vehicle body defining an interior space, and a display panel in the interior space, where the display panel includes a substrate including a display area including a sub-pixel and a non-display area outside the display area, the non-display area including a pad area, a demultiplexer circuit area which is disposed in the non-display area and transmits a data signal to the sub-pixel, a compensation capacitor area between the pad area and the demultiplexer circuit area, the compensation capacitor area including a plurality of compensation capacitors each including a first electrode and a second electrode on the first electrode, and a plurality of fan-out lines extending from the pad area to the compensation capacitor area.

In an embodiment, the vehicle may further include a cluster, a center fascia, and a passenger seat dashboard spaced apart from the cluster with the center fascia therebetween, where the display panel may be on at least one of the cluster, the center fascia, or the passenger seat dashboard.

In an embodiment, the first electrode may be electrically connected to one of the plurality of fan-out lines, and the second electrode may be electrically connected to a power supply line.

In an embodiment, the plurality of fan-out lines may be arranged in a direction away from a central portion of the pad area and may include a first fan-out line and a second fan-out line in a same layer, and a length of the second fan-out line may be greater than a length of the first fan-out line.

In an embodiment, the plurality of compensation capacitors may include a first compensation capacitor electrically connected to the first fan-out line and a second compensation capacitor electrically connected to the second fan-out line, and a capacitance of the first compensation capacitor may be greater than a capacitance of the second compensation capacitor.

In an embodiment, an area of the first electrode of the first compensation capacitor may be greater than an area of the first electrode of the second compensation capacitor, and an area of the second electrode of the first compensation capacitor may be greater than an area of the second electrode of the second compensation capacitor.

In an embodiment, the display panel may further include a light-emitting element in the display area, a first transistor between the substrate and the light-emitting element, and a storage capacitor electrically connected to the first transistor, wherein the first transistor may include a first semiconductor layer and a first gate electrode overlapping a channel region of the first semiconductor layer, and the storage capacitor may include a first capacitor electrode in a same layer as the first gate electrode and a second capacitor electrode on the first capacitor electrode.

In an embodiment, the first electrode may include a same material as a material of the first gate electrode, and the second electrode may include a same material as a material of the second capacitor electrode.

In an embodiment, the display panel may further include a second transistor on the substrate, and a bottom metal layer below the first semiconductor layer, wherein the second transistor may include a second semiconductor layer including an oxide semiconductor, and a second gate electrode on the second semiconductor layer and overlapping a channel region of the second semiconductor layer.

In an embodiment, the first electrode may include a same material as a material of the bottom metal layer, and the second electrode may include a same material as a material of the first gate electrode.

In an embodiment, the first electrode may include a same material as a material of the second capacitor electrode, and the second electrode may include a same material as a material of the second gate electrode.

In an embodiment, the plurality of compensation capacitors may each further include a third electrode on the second electrode and electrically connected to the first electrode, the first electrode may include a same material as a material of the first gate electrode, the second electrode may include a same material as a material of the second capacitor electrode, and the third electrode may include a same material as a material of the second gate electrode.

According to an aspect, there is provided a display panel as set out in claim 1. Additional features are set out in claims 2 to 13. According to an aspect, there is provided a vehicle as set out in claim 14. Additional features are set out in claim 15.

### BRIEF DESCRIPTION OF THE DRAWINGS

The above and other features and advantages of illustrative embodiments of the disclosure will be more apparent from the following description taken in conjunction with the accompanying drawings, in which:
FIG. 1 is a perspective view schematically illustrating an embodiment of a display panel;
FIGS. 2A and 2B are cross-sectional views schematically illustrating an embodiment of the display panel of FIG. 1 taken along line A-A' of FIG. 1;
FIGS. 3 and 4 are plan views schematically illustrating an embodiment of a display panel;
FIGS. 5A and 5B are equivalent circuit diagrams schematically illustrating an embodiment of a sub-pixel of a display panel;
FIG. 6 is an enlarged plan view of region C of FIG. 3;
FIGS. 7A and 7B are plan views illustrating a portion of the display panel illustrated in FIG. 6;
FIG. 8 is a cross-sectional view illustrating an embodiment of a portion of a display panel;
FIG. 9 is a cross-sectional view illustrating an embodiment of a portion of a display panel;
FIG. 10 is a cross-sectional view illustrating an embodiment of a portion of a display panel;
FIG. 11 is a cross-sectional view illustrating an embodiment of a portion of a display panel;
FIG. 12 is a plan view illustrating an embodiment of a display panel;
FIG. 13 is a diagram schematically illustrating an embodiment of the exterior of a vehicle; and
FIGS. 14A and 14B are diagrams schematically illustrating the interior of a vehicle according to various embodiments.

### DETAILED DESCRIPTION

Reference will now be made in detail to embodiments, embodiments of which are illustrated in the accompanying drawings, wherein like reference numerals refer to like elements throughout. In this regard, the illustrated embodiments may have different forms and should not be construed as being limited to the descriptions set forth herein. Accordingly, the embodiments are merely described below, by referring to the drawing figures, to explain features of the description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

As the description allows for various changes and numerous embodiments, illustrative embodiments will be illustrated in the drawings and described in detail in the written description. Effects and features of the disclosure, and methods of achieving them will be clarified with reference to embodiments described below in detail with reference to the drawings. However, the disclosure is not limited to the following embodiments and may be embodied in various forms.

It will be understood that although the terms "first," "second," etc. may be used herein to describe various elements, these elements should not be limited by these terms. These terms are only used to distinguish one element from another.

The singular forms as used herein are intended to include the plural forms as well unless the context clearly indicates otherwise.

It will be further understood that the terms "include" and/or "comprise" used herein specify the presence of stated features or elements, but do not preclude the presence or addition of one or more other features or elements.

It will be further understood that, when a layer, region, or element is also referred to as being "on" another layer, region, or element, it may be directly or indirectly on the other layer, region, or element. That is, e.g., intervening layers, regions, or elements may be present.

In this specification, the expression "A and/or B" indicates only A, only B, or both A and B. In this specification, the expression "at least one of A and B" indicates only A, only B, or both A and B.

In the following embodiments, the expression "a line extends in a first direction or a second direction" may include a case in which "a line extends in a linear shape" and a case in which "a line extends in a zigzag or curved shape in a first direction or a second direction."

In the following embodiments, the term "in a plan view" means seeing a target portion from above, and the term "in a cross-sectional view" means seeing a vertically cut cross-section of a target portion from side. In the following embodiments, the term "overlapping" may include overlapping "in a plan view" and "in a cross-sectional view."

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term "about" can mean within one or more standard deviations, or within ± 30%, 20%, 10%, 5% of the stated value, for example.

Hereinafter, embodiments will be described in detail with reference to the accompanying drawings. When describing embodiments with reference to the accompanying drawings, the same or corresponding elements are denoted by the same reference numerals.

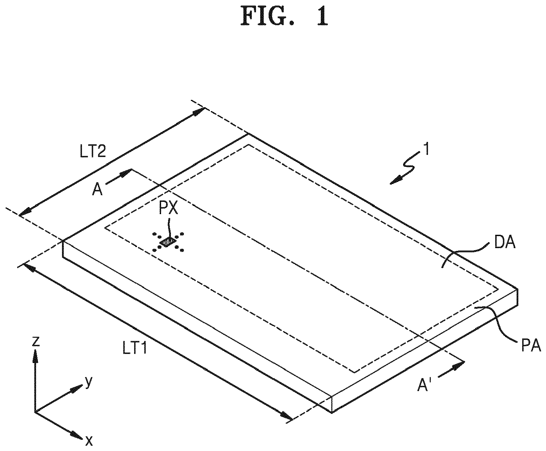

FIG. 1 is a perspective view schematically illustrating an embodiment of a display apparatus1.

Referring to FIG. 1, the display apparatus 1 may display an image. The display apparatus 1 may include a display area DA and a non-display area NDA. A sub-pixel PX may be in the display area DA. The non-display area NDA may at least partially surround the display area DA. No sub-pixel PX may be in the non-display area NDA.

FIG. 1 illustrates the display apparatus 1 in which the display area DA has a quadrangular shape, e.g., rectangular shape, but in another embodiment, the display area DA may have a circular shape, an elliptical shape, or a polygonal shape, such as a triangular shape or a pentagonal shape. As the display apparatus 1, a flat-panel display apparatus is illustrated in FIG. 1, but the display apparatus 1 may be implemented in various forms, such as flexible, foldable, or rollable display apparatuses.

A plurality of sub-pixels PX may be in the display area DA. The sub-pixels PX may emit light, and the display apparatus 1 may display an image in the display area DA. In an embodiment, any one of the sub-pixels PX may emit red light, green light, or blue light. In another embodiment, any one of the sub-pixels PX may emit red light, green light, blue light, or white light.

In an embodiment, a first length LT1 of the display apparatus 1 in the first direction may be greater than a second length LT2 of the display apparatus 1 in the second direction. The number of sub-pixels PX arranged in the first direction may be greater than the number of sub-pixels PX arranged in the second direction. The first direction and the second direction may cross each other. In an embodiment, the first direction and the second direction may be perpendicular to each other, for example. The first direction may be x direction and the second direction may be y direction. In another embodiment, the first direction and the second direction may define an acute angle with each other, or may define an obtuse angle with each other. In another embodiment, the first length LT1 may be less than the second length LT2. In another embodiment, the first length LT1 and the second length LT2 may be equal to each other.

In embodiments, the display apparatus 1 may include a liquid crystal display, an electrophoretic display, an organic light-emitting display, an inorganic electroluminescence ("EL") display (or an inorganic light-emitting display), a field emission display, a surface-conduction electron-emitter display, a quantum dot display, a plasma display, and a cathode ray tube display. Hereinafter, an organic light-emitting display will be described in an embodiment of the display apparatus 1 in an embodiment, but various types of display apparatuses as described above may be used in embodiments.

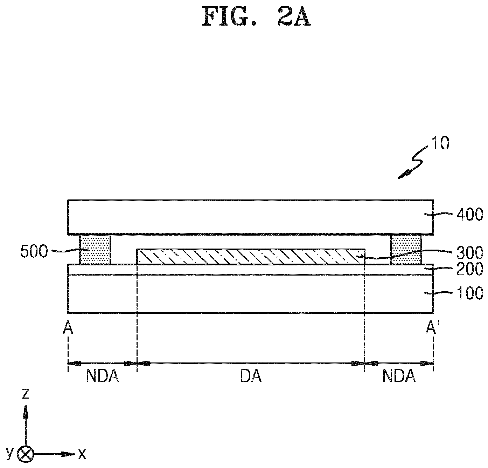

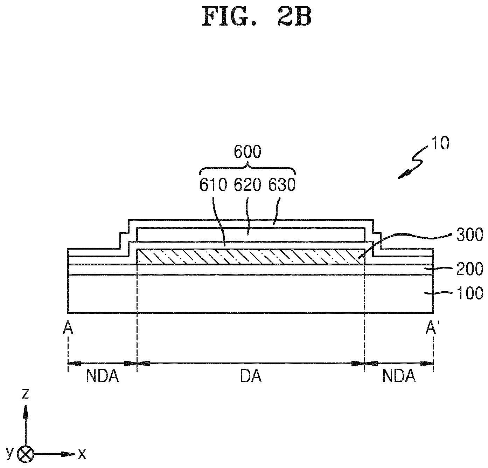

FIGS. 2A and 2B are respectively cross-sectional views schematically illustrating an embodiment of the display apparatus 1 of FIG. 1 taken along line A-A' of FIG. 1.

Referring to FIGS. 2A and 2B, the display apparatus 1 may include a display panel 10, a cover window, and a housing. The display panel 10 may include a substrate 100, an inorganic insulating layer 200, a light-emitting element layer 300, and a sealing structure. The display apparatus 1 may include a display area DA and a non-display area NDA. The display area DA and the non-display area NDA may be defined in the substrate 100. In other words, the substrate 100 may include the display area DA and the non-display area NDA.

In an embodiment, the substrate 100 may include glass or polymer resin. The polymer resin may include polymer resin selected from polyethersulfone, polyarylate, polyether imide, polyethylene naphthalate, polyethylene terephthalate, polyphenylene sulfide, polyimide, polycarbonate, cellulose triacetate, and cellulose acetate propionate. In an embodiment, the substrate 100 may have a structure in which a base layer including polymer resin and a barrier layer including an inorganic insulating material, such as silicon oxide or silicon nitride, are alternately stacked.

The inorganic insulating layer 200 may be disposed on the substrate 100. The inorganic insulating layer 200 may overlap the display area DA and the non-display area NDA. In the specification, the expression "a first element and a second element overlap each other" means that the first element and the second element overlap each other in a plan view (e.g., an xy plane). The inorganic insulating layer 200 may include an inorganic insulating material, such as silicon oxide, silicon nitride, silicon oxynitride, aluminum oxide, titanium oxide, tantalum oxide, hafnium oxide, and/or zinc oxide. In an embodiment, the zinc oxide may be ZnO and/or ZnO₂.

The light-emitting element layer 300 may be disposed on the inorganic insulating layer 200. The light-emitting element layer 300 may overlap the display area DA. The light-emitting element layer 300 may include a light-emitting element. The light-emitting element may be an organic light-emitting diode including an organic emission layer. In an alternative embodiment, the light-emitting element may be an inorganic light-emitting diode including an inorganic emission layer. The size of the inorganic light-emitting diode may be on a micro scale or a nano scale. In an embodiment, the inorganic light-emitting diode may be a micro light-emitting diode, for example. In an alternative embodiment, the inorganic light-emitting diode may be a nanorod light-emitting diode. The nanorod light-emitting diode may include gallium nitride (GaN). In an embodiment, a color conversion layer may be disposed on the nanorod light-emitting diode. The color conversion layer may include quantum dots. In an alternative embodiment, the light-emitting element may be a quantum dot light-emitting diode including a quantum dot emission layer.

Referring to FIG. 2A, the sealing structure may include a sealing substrate 400 and a sealing member 500. The sealing substrate 400 may be disposed on the light-emitting element layer 300. In other words, the light-emitting element layer 300 may be between the substrate 100 and the sealing substrate 400. The sealing substrate 400 may be a transparent member. In an embodiment, the sealing substrate 400 may include glass.

The sealing member 500 may be between the substrate 100 and the sealing substrate 400. In an embodiment, the sealing member 500 may be between the inorganic insulating layer 200 and the sealing substrate 400. The sealing member 500 may surround the display area DA in a plan view. The sealing member 500 may overlap the non-display area NDA in a plan view. Therefore, the inner space between the light-emitting element layer 300 and the sealing substrate 400 may be sealed, and a moisture absorbent and/or a filler may be in the inner space.

In an embodiment, the sealing member 500 may be a sealant. In another embodiment, the sealing member 500 may include a material that is curable by a laser. In an embodiment, the sealing member 500 may be frit, for example. Specifically, the sealing member 500 may include an inorganic sealant or an organic sealant, such as a urethane-based resin, an epoxy-based resin, and an acrylic resin. In an embodiment, the sealing member 500 may include silicone. In embodiments, the urethane-based resin may include urethane acrylate. In embodiments, the acrylic resin may include butyl acrylate and ethylhexyl acrylate. The sealing member 500 may include a material that is curable by heat.

Referring to FIG. 2B, the sealing structure may include an encapsulation layer 600. The encapsulation layer 600 may include at least one inorganic encapsulation layer and at least one organic encapsulation layer. The at least one inorganic encapsulation layer and the at least one organic encapsulation layer may be alternately stacked. In an embodiment, the encapsulation layer 600 may include a first inorganic encapsulation layer 610, an organic encapsulation layer 620, and a second inorganic encapsulation layer 630, which are sequentially stacked in this stated order. The first inorganic encapsulation layer 610 and the second inorganic encapsulation layer 630 may come in contact with each other in the non-display area NDA. The inorganic encapsulation layer may include an inorganic insulating material, such as silicon oxide, silicon nitride, silicon oxynitride, aluminum oxide, titanium oxide, tantalum oxide, hafnium oxide, and/or zinc oxide. In an embodiment, the zinc oxide may be ZnO and/or ZnO₂.

The organic encapsulation layer may include a polymer-based material. The polymer-based material may include acrylic resin, epoxy-based resin, polyimide, polyethylene, or the like. In an embodiment, the organic encapsulation layer may include acrylate.

In another embodiment, the sealing structure may include the sealing substrate 400 and the sealing member 500 of FIG. 2A and the encapsulation layer 600 of FIG. 2B at the same time. Hereinafter, the sealing structure including the encapsulation layer 600 is mainly described.

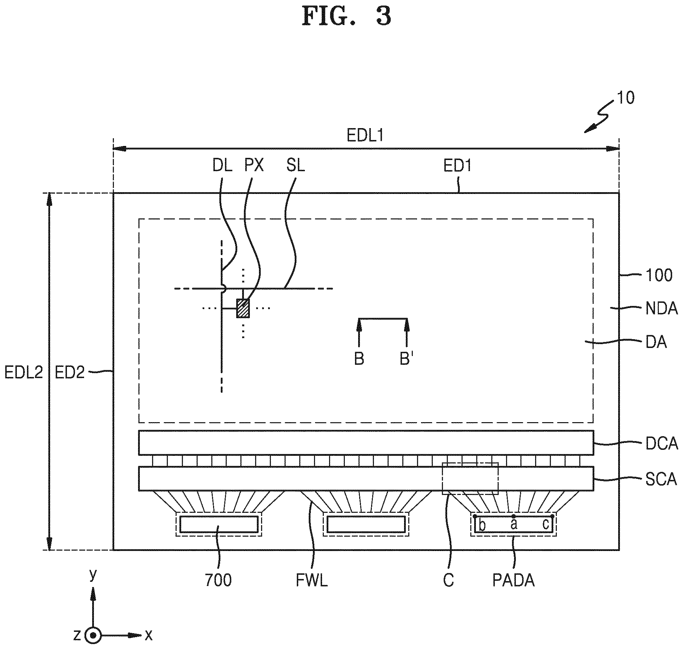

FIG. 3 is a plan view schematically illustrating an embodiment of a display panel 10.

Referring to FIG. 3, the display panel 10 may include a substrate 100, a sub-pixel PX, a data line DL, a scan line SL, a driver 700, a fan-out line FWL, a compensation capacitor, and a demultiplexer circuit. The substrate 100 may have a first edge ED1 and a second edge ED2. The first edge ED1 may extend in the first direction (e.g., the x direction). The second edge ED2 may extend in the second direction (e.g., the y direction). In an embodiment, a length EDL1 of the first edge ED1 may be greater than a length EDL2 of the second edge ED2. The number of sub-pixels PX arranged in the first direction (e.g., the x direction) may be greater than the number of sub-pixels PX arranged in the second direction (e.g., the y direction).

The substrate 100 may include a display area DA and a non-display area NDA. The display area DA may be an area in which the display apparatus 1 displays an image. The sub-pixel PX may be in the display area DA. A plurality of sub-pixels PX may be in the display area DA. The sub-pixel PX may be electrically connected to the data line DL. The scan line SL may extend in the first direction (e.g., the x direction). The data line DL may extend in the second direction (e.g., the y direction). In a plan view, the scan line SL and the data line DL may overlap the display area DA.

The non-display area NDA may be adjacent to the display area DA. In an embodiment, the non-display area NDA may surround the display area DA. The non-display area NDA may be an area in which the display apparatus 1 does not display an image. No sub-pixel PX may be in the non-display area NDA.

The non-display area NDA may include a pad area PADA. The pad area PADA may be outside the display area DA. In an embodiment, a plurality of pad areas PADA may be provided. In other words, the pad area PADA may include a plurality of pad areas PADA. In an embodiment, the pad areas PADA may be arranged in parallel in the first direction (e.g., the x direction). FIG. 3 illustrates the pad areas PADA, but in another embodiment, the display apparatus 1 may include one pad area PADA. FIG. 3 illustrates that the pad area PADA is outside the display area DA in the -y direction, but in another embodiment, the pad area PADA may be outside the display area DA in the y direction, the -x direction, or the x direction.

The non-display area NDA may include a demultiplexer circuit area DCA. The demultiplexer circuit area DCA may be between the pad area PADA and the display area DA. The demultiplexer circuit area DCA may be arranged adjacent to the display area DA. A plurality of demultiplexer circuits (not shown) may be in the demultiplexer circuit area DCA. The demultiplexer circuit may receive a data signal from one data input line and output the data signal to a plurality of data output lines. In an alternative embodiment, the demultiplexer circuit may receive data signals from n data input lines and output the data signals to m data output lines. In this case, n and m may be natural numbers satisfying a condition of n being less than m (n<m). In this manner, power consumption of the display apparatus 1 may be reduced, and dead space may be reduced by efficiently utilizing the space where lines or wires are in the non-display area NDA.

In an embodiment, the demultiplexer circuit area DCA may extend in the first direction (e.g., the x direction). The demultiplexer circuits may be arranged in parallel in the first direction (e.g., the x direction). In an alternative embodiment, the demultiplexer circuit area DCA may extend to correspond to the shape of the display area DA. That is, the demultiplexer circuits may be arranged along the edge of the display area DA.

The driver 700 may be in the pad area PADA. Although not illustrated, a pad may be in the pad area PADA and the driver 700 may be electrically connected to the pad. The driver 700 may generate signals and voltages for driving the display apparatus 1. The signals and/or voltages generated by the driver 700 may be transmitted through the fan-out line FWL to the sub-pixel PX arranged in the display area DA. The driver 700 may include an integrated circuit ("IC"). The driver 700 may be electrically connected to the pad through an anisotropic conductive film. In some embodiments, the driver 700 may be a printed circuit board. The printed circuit board may be a flexible printed circuit board or a rigid printed circuit board. In an alternative embodiment, in some cases, the driver 700 may be a composite printed circuit board including both the rigid printed circuit board and the flexible printed circuit board. The IC may be on the printed circuit board.

The fan-out line FWL may extend in a direction from the pad area PADA to the display area DA. The fan-out line FWL may overlap the non-display area NDA in a plan view. In an embodiment, a plurality of fan-out lines FWL may be provided. In an embodiment, the fan-out line FWL may extend from the pad areas PADA to the display area DA. In an embodiment, the fan-out line FWL may be a signal line. The fan-out line FWL may be electrically connected to the data line DL. In another embodiment, the fan-out line FWL may be a power supply line. Hereinafter, a case where the fan-out line FWL is a signal line electrically connected to the data line DL is mainly described.

The length of the fan-out line FWL may vary depending on the arrangement position. In an embodiment, as the fan-out line FWL is arranged farther away from the center of the pad area PADA, the fan-out line FWL may extend toward a point of the display area DA farther away from the pad area PADA, for example. In an embodiment, the length of the fan-out line FWL may increase from point a, which is the center of the pad area PADA, to point b and point c, which are opposite ends of the pad area PADA.

The fan-out line FWL may be electrically connected to the demultiplexer circuit of the demultiplexer circuit area DCA. Specifically, the fan-out line FWL may be electrically connected to the data input line of the demultiplexer circuit. The data output line of the demultiplexer circuit may be electrically connected to the data line DL. Accordingly, the fan-out line FWL may be electrically connected to the data line DL of the display area DA through the demultiplexer circuit arranged in the demultiplexer circuit area DCA. The data line DL may be electrically connected to the fan-out line FWL and receive the data signal.

The compensation capacitor area SCA may be between the pad area PADA and the demultiplexer circuit area DCA. The compensation capacitor area SCA may be arranged adjacent to the demultiplexer circuit area DCA. The compensation capacitor area SCA may include a plurality of compensation capacitors. As will be described below, the compensation capacitors may compensate for a capacitance deviation between the fan-out line FWL and the power supply line according to the arrangement position and length of the fan-out line FWL. The fan-out line FWL may be electrically connected to the compensation capacitor area SCA. The fan-out line FWL may be electrically connected to the compensation capacitor. The fan-out line FWL may be electrically connected to the demultiplexer circuit area DCA through the compensation capacitor area SCA. The fan-out line FWL may be electrically connected to the demultiplexer circuit of the demultiplexer circuit area DCA through the compensation capacitor of the compensation capacitor area SCA.

In an embodiment, the compensation capacitor area SCA may extend in the first direction (e.g., the x direction). The compensation capacitors may be arranged in parallel in the first direction (e.g., the x direction).

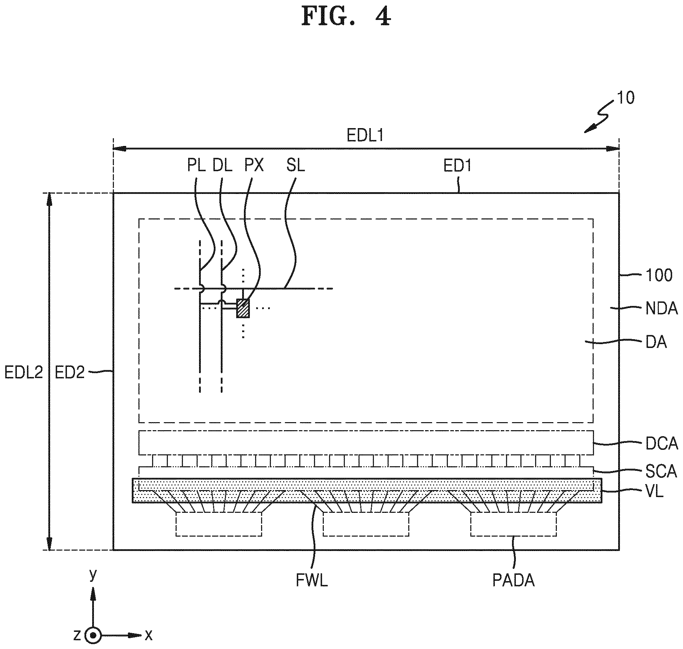

FIG. 4 is a plan view schematically illustrating an embodiment of a display panel 10. FIG. 4 illustrates a driving voltage line PL and a power supply line VL on the display panel 10.

Referring to FIG. 4, a sub-pixel PX may be electrically connected to the driving voltage line PL. The driving voltage line PL may extend in the second direction (e.g., the y direction). In a plan view, the driving voltage line PL may overlap a display area DA.

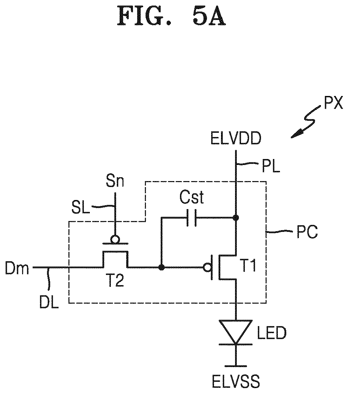

The power supply line VL may extend in the first direction (e.g., the x direction). In a plan view, the power supply line VL may overlap a non-display area NDA. In an embodiment, the power supply line VL may overlap a fan-out line FWL and a compensation capacitor area SCA. In another embodiment, the power supply line VL may overlap the fan-out line FWL, the compensation capacitor area SCA, and a demultiplexer circuit area DCA. In an embodiment, the power supply line VL may be a driving voltage supply line or a common voltage supply line. Hereinafter, a case where the power supply line VL is a driving voltage supply line is mainly described. The power supply line VL may be electrically connected to the driving voltage line PL. That is, the driving voltage line PL may be electrically connected to the power supply line VL and receive a driving voltage ELVDD (refer to FIG. 5A). Also, the power supply line VL may be electrically connected to the compensation capacitors of the compensation capacitor area SCA.

The fan-out line FWL may overlap the power supply line VL disposed in a different layer in a predetermined area. A capacitance may be formed in an area in which the power supply line VL overlaps the fan-out line FWL. In an embodiment, the power supply line VL may extend in the first direction (e.g., the x direction) while having a constant width in the second direction (e.g., the y direction) in a predetermined area, and the capacitance between the power supply line VL and the fan-out line FWL may vary depending on the length of the fan-out line FWL passing through the overlapping area. The capacitance between the power supply line VL and the fan-out line FWL may be proportional to the length of the fan-out line FWL. As described above, the length of the fan-out line FWL may vary depending on the arrangement position of the fan-out line FWL. In an embodiment, as the fan-out line FWL is arranged in a direction away from the center of the pad area PADA, the length of the fan-out line FWL increases. Accordingly, a relatively large capacitance may be formed between the fan-out line FWL and the power supply line VL.

Compensation capacitors in the compensation capacitor area SCA may compensate for a capacitance deviation between the fan-out line FWL and the power supply line VL according to the arrangement position and length of the fan-out line FWL. Specifically, the difference in capacitance between each fan-out line FWL and the power supply line VL may be compensated for by varying the capacitance of the compensation capacitor connected to each fan-out line FWL.

As a comparative example, when the display apparatus does not include a compensation capacitor area including a plurality of compensation capacitors, a relatively large capacitance deviation may occur between the fan-out line and the power supply line. As the difference between a maximum value and a minimum value of the capacitance between the fan-out line and the power supply line increases, a kickback deviation of transistors in the demultiplexer circuit area may increase. In this case, because the demultiplexer circuit is electrically connected to the data line of the display area, the display quality of the display apparatus 1 may deteriorate. In an embodiment, a dark line may be observed in the display area, for example.

However, in an embodiment, because the display apparatus 1 includes the compensation capacitor area SCA including the compensation capacitors, the difference in capacitance between the fan-out line FWL and the power supply line VL according to the length of the fan-out line FWL may be compensated for. Accordingly, a kickback deviation of transistors in the demultiplexer circuit area DCA may be reduced, and a dark line may not be observed in the display area DA. Accordingly, the display quality of the display apparatus 1 may be improved. Also, the reliability of the display apparatus 1 may be improved.

FIGS. 5A is an equivalent circuit diagram schematically illustrating an embodiment of a sub-pixel PX of a display panel.

Referring to FIG. 5A, the sub-pixel PX may include a sub-pixel circuit PC and a light-emitting element LED electrically connected to the sub-pixel circuit PC. In an embodiment, the sub-pixel circuit PC may include a driving transistor T1, a switching transistor T2, and a storage capacitor Cst. The sub-pixel PX may emit red light, green light, or blue light through the light-emitting element LED, or may emit red light, green light, blue light, or white light through the light-emitting element LED.

The switching transistor T2 may be connected to a scan line SL and a data line DL and may transmit, to the driving transistor T1, a data voltage or a data signal Dm input from the data line DL in response to a scan voltage or a scan signal Sn input from the scan line SL.

The storage capacitor Cst may be connected to the switching transistor T2 and a driving voltage line PL and may store a voltage corresponding to a difference between a voltage received from the switching transistor T2 and a driving voltage ELVDD supplied to the driving voltage line PL.

The driving transistor T1 may be connected to the driving voltage line PL and the storage capacitor Cst and may control a driving current flowing from the driving voltage line PL to the light-emitting element LED according to a voltage value stored in the storage capacitor Cst. The light-emitting element LED may emit light having a predetermined luminance according to the driving current. An opposite electrode (e.g., a cathode) of the light-emitting element LED may receive a common voltage ELVSS.

FIG. 5A illustrates that the sub-pixel circuit PC includes two transistors and one storage capacitor, but in another embodiment, the sub-pixel circuit PC may include three or more transistors.

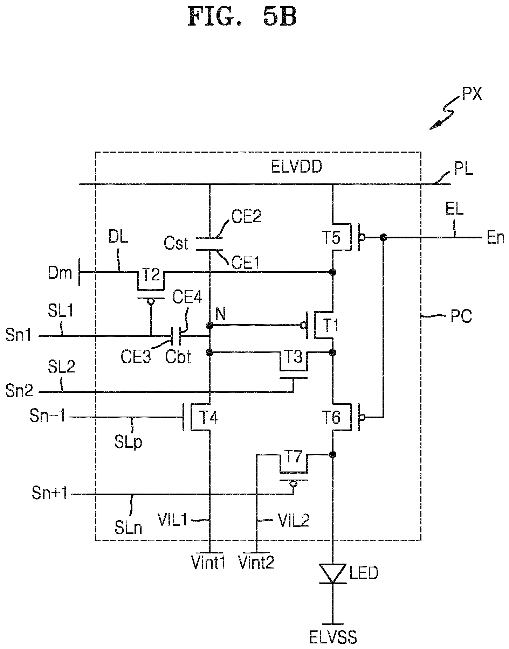

FIGS. 5B is an equivalent circuit diagram schematically illustrating an embodiment of a sub-pixel PX of a display panel.

Referring to FIG. 5B, a sub-pixel circuit PC may include a plurality of transistors T1 to T7 and a storage capacitor Cst. The transistors T1 to T7 and the storage capacitor Cst may be connected to signal lines SL1, SL2, SLp, SLn, EL, and DL, a first initialization voltage line VIL1, a second initialization voltage line VIL2, and a driving voltage line PL. In an embodiment, at least one of the signal lines SL1, SL2, SLp, SLn, EL, and DL, the first and second initialization lines VIL1 and VIL2, and/or the driving voltage line PL may be shared by neighboring sub-pixels PX.

In an embodiment, the transistors T1 to T7 may include a driving transistor T1, a switching transistor T2, a compensation transistor T3, a first initialization transistor T4, an operation control transistor T5, an emission control transistor T6, and a second initialization transistor T7. However, embodiments of the disclosure are not limited thereto.

A light-emitting element LED may include a sub-pixel electrode and an opposite electrode. The sub-pixel electrode of the light-emitting element LED may be connected to the driving transistor T1 through the light-emitting control transistor T6 and receive a driving current. The opposite electrode may receive a common voltage ELVSS. The light-emitting element LED may emit light having a luminance corresponding to the driving current. In an embodiment, the light-emitting element LED may be an organic light-emitting diode including an organic emission layer.

The driving voltage line PL may transmit a driving voltage ELVDD to the driving transistor T1. The first initialization voltage line VIL1 may transmit, to the sub-pixel circuit PC, a first initialization voltage Vint1 for initializing the driving transistor T1. The second initialization voltage line VIL2 may transmit, to the sub-pixel circuit PC, a second initialization voltage Vint2 for initializing the light-emitting element LED.

In an embodiment, among the driving transistor T1, the switching transistor T2, the compensation transistor T3, the first initialization transistor T4, the operation control transistor T5, the emission control transistor T6, and the second initialization transistor T7, the compensation transistor T3 and the first initialization transistor T4 may each be implemented as an n-channel metal-oxide semiconductor field effect transistor ("MOSFET") ("NMOS"), and the remaining transistors may each be implemented as a p-channel MOSFET ("PMOS").

A drain region of the driving transistor T1 may be electrically connected to the light-emitting element LED via the emission control transistor T6. The driving transistor T1 may receive a data signal Dm according to the switching operation of the switching transistor T2 and supply a driving current to the light-emitting element LED.

The switching transistor T2 may be turned on in response to a first scan signal Sn1 received through the first scan line SL1 and perform a switching operation of transmitting, to a source region of the driving transistor T1, the data signal Dm received from the data line DL.

A gate electrode of the compensation transistor T3 may be connected to the second scan line SL2. A source region of the compensation transistor T3 may be connected to a drain region of the driving transistor T1 and connected to the sub-pixel electrode of the light-emitting element LED via the emission control transistor T6. A drain electrode of the compensation transistor T3 may be connected to one electrode of the first storage capacitor Cst, a source region of the first initialization transistor T4, and a gate electrode of the driving transistor T1. The compensation transistor T3 may be turned on in response to a second scan signal Sn2 received through the second scan line SL2 and diode-connect the gate electrode of the driving transistor T1 to the drain electrode of the driving transistor T1. Therefore, the driving transistor T1 may be diode-connected.

A gate electrode of the first initialization transistor T4 may be connected to the previous scan line SLp. A drain region of the first initialization transistor T4 may be connected to the first initialization voltage line VIL1. The source region of the first initialization transistor T4 may be connected to one electrode of the first storage capacitor Cst, the drain region of the third compensation transistor T3, and the gate electrode of the driving transistor T1. The first initialization transistor T4 may be turned on in response to a previous scan signal Sn-1 received through the previous scan line SLp and perform an initialization operation of transmitting the first initialization voltage Vint1 to the driving transistor T1 so as to initialize the voltage of the driving gate of the driving transistor T1.

A gate electrode of the second initialization transistor T7 may be connected in the next scan line SLn. A source region of the second initialization transistor T7 may be connected to the sub-pixel electrode of the light-emitting element LED. A drain region of the second initialization transistor T7 may be connected to the second initialization voltage line VIL2. The second initialization transistor T7 may be turned on in response to a next scan signal Sn+1 received through the next scan line SLn and initialize the sub-pixel electrode of the light-emitting element LED.

The first storage capacitor Cst may include a first capacitor electrode CE1 and a second capacitor electrode CE2. The first capacitor electrode CE1 may be connected to the gate electrode of the driving transistor T1, and the second capacitor electrode CE2 may be connected to the driving voltage line PL. The first storage capacitor Cst may store and maintain a voltage corresponding to a voltage difference between the driving voltage line PL and the gate electrode of the driving transistor T1, and thus, a voltage applied to the gate electrode of the driving transistor T1 may be maintained.

A second storage capacitor Cbt may include a third capacitor electrode CE3 and a fourth capacitor electrode CE4. The third capacitor electrode CE3 may be connected to the first scan line SL1 and the gate electrode of the switching transistor T2. The fourth capacitor electrode CE4 may be connected to the gate electrode of the driving transistor T1 and the first capacitor electrode CE1 of the first storage capacitor Cst. The second storage capacitor Cbt may act as a boosting capacitor. When the first scan signal Sn1 of the first scan line SL1 is a voltage to turn off the switching transistor T2, the second storage capacitor Cbt may increase a voltage of a node N to reduce a voltage (black voltage) that displays black.

A detailed operation of each sub-pixel circuit PC in an embodiment is as follows.

During a first initialization period, when the previous scan signal Sn-1 is supplied through the previous scan line SLp, the first initialization transistor T4 may be turned on in response to the previous scan signal Sn-1, and the driving transistor T1 may be initialized by the first initialization voltage Vint1 supplied from the first initialization voltage line VIL1.

During a data programming period, when the first scan signal Sn1 and the second scan signal Sn2 are respectively supplied through the first scan line SL1 and the second scan line SL2, the switching transistor T2 and the compensation transistor T3 may be respectively turned on in response to the first scan signal Sn1 and the second scan signal Sn2. At this time, the driving transistor T1 may be diode-connected by the turned-on compensation transistor T3 and may be forward biased. A voltage obtained by compensating for a threshold voltage of the driving transistor T1 in the data signal Dm supplied from the data line DL may be applied to the gate electrode of the driving transistor T1. The driving voltage ELVDD and the compensation voltage may be applied to both electrodes of the first storage capacitor Cst, and charges corresponding to the voltage difference between both electrodes of the first storage capacitor Cst may be stored in the first storage capacitor Cst.

During an emission period, the operation control transistor T5 and the emission control transistor T6 may be turned on in response to the emission control signal En supplied from the emission control line EL. The driving current corresponding to the difference between the voltage of the gate electrode of the driving transistor T1 and the driving voltage ELVDD may be generated, and the driving current may be supplied to the light-emitting element LED through the emission control transistor T6.

During a second initialization period, when the next scan signal Sn+1 is supplied through the next scan line SLn, the second initialization transistor T7 may be turned on in response to the next scan signal Sn+1, and the light-emitting element LED may be initialized by the second initialization voltage Vint2 supplied from the second initialization voltage line VIL2.

In an embodiment, at least one of the transistors T1 to T7 may include an oxide-based transistor including an oxide semiconductor, and the remaining transistors may include a silicon-based transistor including a silicon semiconductor.

Specifically, the driving transistor T1 that directly influences the brightness of the display apparatus may include a semiconductor layer including polycrystalline silicon having relatively high reliability, and thus, a high-resolution display apparatus may be implemented.

Because the oxide semiconductor has relatively high carrier mobility and relatively low leakage current, the voltage drop may not be substantially great even when the driving time is substantially long. That is, the color change of the image according to the voltage drop is not substantially great even during low-frequency driving. Therefore, the low-frequency driving is possible.

As described above, in the case of the oxide semiconductor, the leakage current is small. Therefore, when at least one of the compensation transistor T3, the first initialization transistor T4, and the second initialization transistor T7, which are connected to the gate electrode of the driving transistor T1, includes the oxide semiconductor, the leakage current that may flow into the gate electrode of the driving transistor T1 may be prevented and power consumption may be reduced.

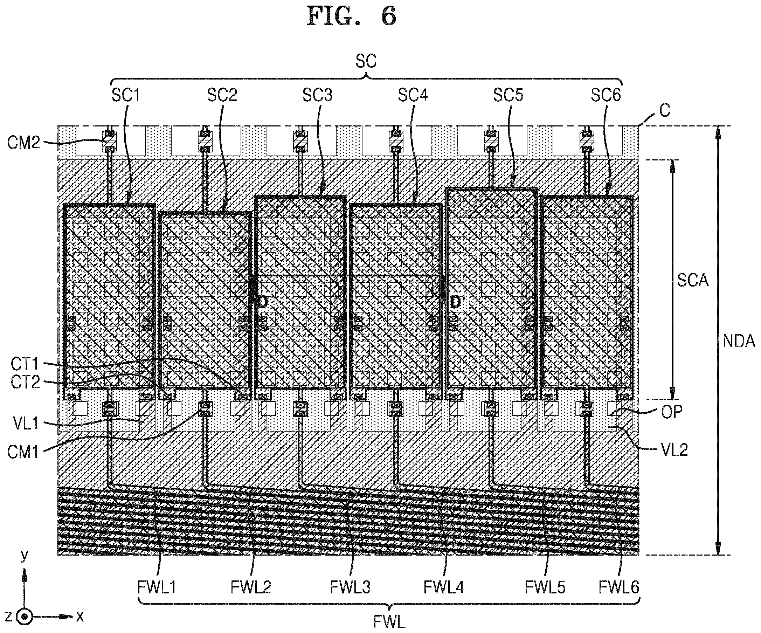

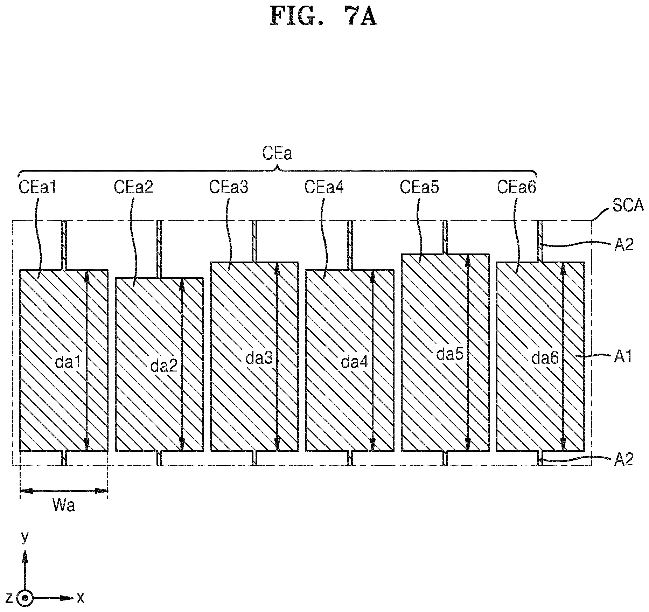

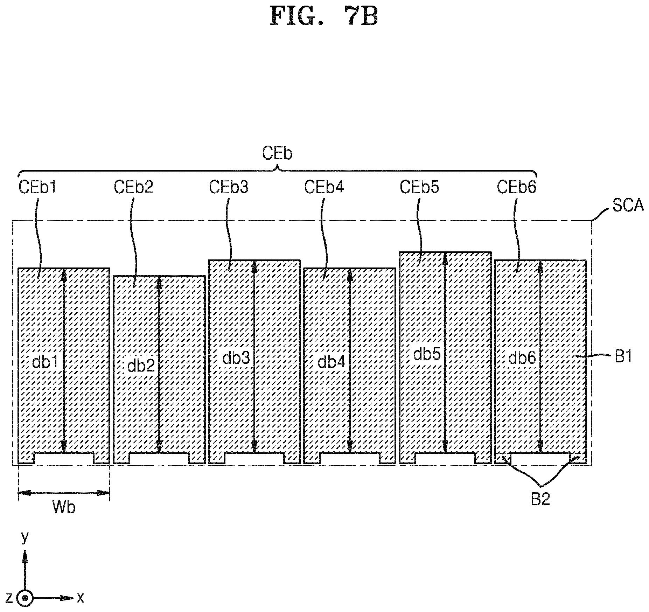

FIG. 6 is an enlarged plan view illustrating an embodiment of region C of the display panel of FIG. 3. FIGS. 7A and 7B are respectively plan views illustrating some layers of the display panel illustrated in FIG. 6.

Referring to FIGS. 6, 7A, and 7B, the display panel may include a substrate, a fan-out line FWL, and a compensation capacitor SC.

The substrate may include a non-display area NDA. The fan-out line FWL may be in the non-display area NDA. The fan-out line FWL may extend in a direction from a pad area to a display area. In an embodiment, the fan-out line FWL may extend in the second direction (e.g., the y direction). In an alternative embodiment, the fan-out line FWL may extend in a direction crossing the first direction (e.g., the x direction) and the second direction (e.g., the y direction). The fan-out line FWL may include a plurality of fan-out lines FWL. In an embodiment, the fan-out lines FWL may include first to sixth fan-out lines FWL1, FWL2, FWL3, FWL4, FWL5, and FWL6. Although FIG. 6 illustrates six fan-out lines FWL, embodiments of the disclosure are not limited thereto. More fan-out lines FWL may be in the non-display area NDA. In an embodiment, the first to sixth fan-out lines FWL1, FWL2, FWL3, FWL4, FWL5, and FWL6 may be sequentially arranged in a direction from the end of the pad area toward the central portion.

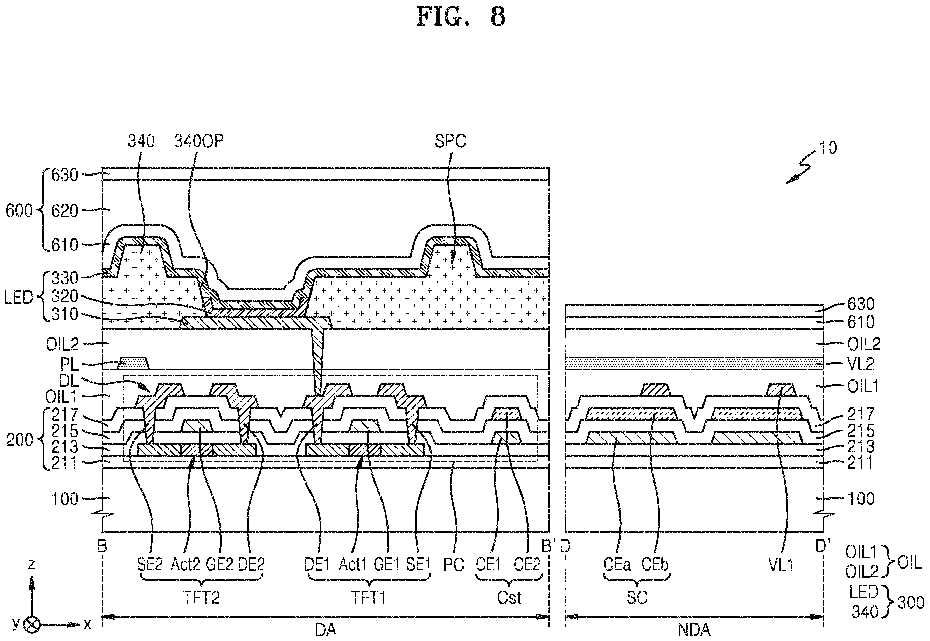

In an embodiment, the first, third, and fifth fan-out lines FWL1, FWL3, and FWL5 may be in the same layer. The second, fourth, and sixth fan-out lines FWL2, FWL4, and FWL6 may be in the same layer. The first, third, and fifth fan-out lines FWL1, FWL3, and FWL5 and the second, fourth, and sixth fan-out lines FWL2, FWL4, and FWL6 may be in different layers from each other. In an embodiment, the first, third, and fifth fan-out lines FWL1, FWL3, and FWL5 may be between a first inorganic insulating layer (refer to 213 of FIG. 8) and a second inorganic insulating layer (refer to 215 of FIG. 8), and the second, fourth, and sixth fan-out lines FWL2, FWL4, and FWL6 may be between the second inorganic insulating layer (refer to 215 of FIG. 8) and a third inorganic insulating layer (refer to 217 of FIG. 8), for example. In another embodiment, all the first to sixth fan-out lines FWL1, FWL2, FWL3, FWL4, FWL5, and FWL6 may be in the same layer.

The non-display area NDA may include a compensation capacitor area SCA. The compensation capacitor area SCA may include a plurality of compensation capacitors SC. The number of compensation capacitors SC may correspond to the number of fan-out lines FWL. In an embodiment, the compensation capacitors SC may include first to sixth compensation capacitors SC1, SC2, SC3, SC4, SC5, and SC6. The first to sixth fan-out lines FWL1, FWL2, FWL3, FWL4, FWL5, and FWL6 may be electrically connected to the first to sixth compensation capacitors SC1, SC2, SC3, SC4, SC5, and SC6 arranged in the compensation capacitor area SCA, respectively.

The compensation capacitor SC may include a first electrode CEa and a second electrode CEb over the first electrode CEa. The second electrode CEb may overlap the first electrode CEa with an insulating layer therebetween. In an embodiment, the first electrode CEa of the compensation capacitor SC may overlap the second electrode CEb of the compensation capacitor SC with the second inorganic insulating layer (refer to 215 of FIG. 8) therebetween, for example. At this time, the second inorganic insulating layer (refer to 215 of FIG. 8) may act as a dielectric layer.

The fan-out line FWL may be electrically connected to the compensation capacitor SC through a first connecting member CM1. Specifically, the fan-out line FWL may be electrically connected to the first connecting member CM1 through a contact hole, and the first connecting member CM1 may be electrically connected to the first electrode CEa of the compensation capacitor SC through a contact hole. The fan-out line FWL may be electrically connected to the first electrode CEa of the compensation capacitor SC through the first connecting member CM1.

The compensation capacitor SC may be electrically connected to the demultiplexer circuit of the demultiplexer circuit area (refer to DCA of FIG. 3) through a second connecting member CM2. Specifically, the first electrode CEa of the compensation capacitor SC may be electrically connected to the second connecting member CM2 through a contact hole. The second connecting member CM2 may be electrically connected to the data input line of the demultiplexer circuit. The first electrode CEa of the compensation capacitor SC may be electrically connected to the demultiplexer circuit through the second connecting member CM2.

In an embodiment, the first electrode CEa of the compensation capacitor SC may include a first portion A1 and a second portion A2. The first portion A1 may be a portion overlapping the second electrode CEb. In an embodiment, the first portion A1 may have a quadrangular shape, e.g., rectangular shape in a plan view. However, embodiments of the disclosure are not limited thereto. In another embodiment, the first portion A1 may be variously modified. In an embodiment, the first portion A1 may have a circular shape, a triangular shape, or a pentagonal shape, for example. The second portion A2 may extend in the second direction (e.g., the y direction) and may be connected to the fan-out line FWL or the demultiplexer circuit.

In an embodiment, the second electrode CEb of the compensation capacitor SC may include a first portion B1 and a second portion B2. The first portion B1 may be a portion overlapping the first electrode CEa. In an embodiment, the first portion B1 may have a quadrangular shape, e.g., rectangular shape in a plan view. However, embodiments of the disclosure are not limited thereto. In another embodiment, the first portion B1 may be variously modified. In an embodiment, the first portion B1 may have a circular shape, a triangular shape, or a pentagonal shape, for example. Hereinafter, a case where the first portion A1 of the first electrode CEa and the first portion B1 of the second electrode CEb each have a quadrangular shape, e.g., rectangular shape is mainly described. The second portion B2 may be a portion connected to a first power supply line VL1.

The first power supply line VL1 may overlap at least portions of the fan-out line FWL and the compensation capacitor area SCA. The first power supply line VL1 may be electrically connected to the second electrode CEb of the compensation capacitor SC through a first contact hole CT1 and a second contact hole CT2. In an embodiment, the first power supply line VL1 may be in the same layer as the first connecting member CM1 and/or the second connecting member CM2 and may include the same material.

The first power supply line VL1 may extend in the first direction (e.g., the x direction) while having a constant width in the second direction (e.g., the y direction) in a predetermined area. In the predetermined area, the first power supply line VL1 may overlap the fan-out line FWL. The capacitance may be formed between the fan-out line FWL and the first power supply line VL1.

In an embodiment, in the case of the first fan-out line FWL1 and the second fan-out line FWL2 in different layers from each other, the first fan-out line FWL1 may overlap the first power supply line VL1 with the second inorganic insulating layer 215, the third inorganic insulating layer 217, and a first organic insulating layer OIL1 therebetween. The second fan-out line FWL2 adjacent to the first fan-out line FWL1 may overlap the first power supply line VL1 with the third inorganic insulating layer 217 and the first organic insulating layer OIL1 therebetween, for example. The capacitance between the second fan-out line FWL2 and the first power supply line VL1 may be greater than the capacitance between the first fan-out line FWL1 and the first power supply line VL1.

As described above, the capacitance between the fan-out line FWL and the first power supply line VL1 may vary depending on the arrangement position and length of the fan-out line FWL. In an embodiment, in the case of the first fan-out line FWL1, the third fan-out line FWL3, and the fifth fan-out line FWL5 in the same layer, the length of the first fan-out line FWL1 may be greater than the length of the third fan-out line FWL3, and the length of the third fan-out line FWL3 may be greater than the length of the fifth fan-out line FWL5, for example. Therefore, the capacitance between the first fan-out line FWL1 and the first power supply line VL1 may be greater than the capacitance between the third fan-out line FWL3 and the first power supply line VL1. The capacitance between the third fan-out line FWL3 and the first power supply line VL1 may be greater than the capacitance between the fifth fan-out line FWL5 and the first power supply line VL1.

Similarly, in the case of the second fan-out line FWL2, the fourth fan-out line FWL4, and the sixth fan-out line FWL6 in the same layer, the length of the second fan-out line FWL2 may be greater than the length of the fourth fan-out line FWL4, and the length of the fourth fan-out line FWL4 may be greater than the length of the sixth fan-out line FWL6. Therefore, the capacitance between the second fan-out line FWL2 and the first power supply line VL1 may be greater than the capacitance between the fourth fan-out line FWL4 and the first power supply line VL1. The capacitance between the fourth fan-out line FWL4 and the first power supply line VL1 may be greater than the capacitance between the sixth fan-out line FWL6 and the first power supply line VL1.

The compensation capacitors SC may be provided in order to compensate for a deviation in capacitance between the fan-out line FWL and the first power supply line VL1 according to the position and length of the fan-out line FWL. Because the compensation capacitors SC respectively connected to the fan-out lines FWL have different capacitances from each other, a capacitance deviation between the fan-out line FWL and the first power supply line VL1 may be improved.

In an embodiment, the capacitance of the first compensation capacitor SC1 electrically connected to the first fan-out line FWL1 may be greater than the capacitance of the second compensation capacitor SC2 electrically connected to the second fan-out line FWL2, for example.

The capacitance of the third compensation capacitor SC3 electrically connected to the third fan-out line FWL3 may be greater than the capacitance of the first compensation capacitor SC1. The capacitance of the fifth compensation capacitor SC5 electrically connected to the fifth fan-out line FWL5 may be greater than the capacitance of the third compensation capacitor SC3.

Similarly, the capacitance of the fourth compensation capacitor SC4 electrically connected to the fourth fan-out line FWL4 may be greater than capacitance of the second compensation capacitor SC2. The capacitance of the sixth compensation capacitor SC6 electrically connected to the sixth fan-out line FWL6 may be greater than the capacitance of the fourth compensation capacitor SC4.

Referring to FIG. 7A, the size of a first electrode CEa3 of the third compensation capacitor SC3 may be greater than the size of a first electrode CEa1 of the first compensation capacitor SC1. The size of a first electrode CEa5 of the fifth compensation capacitor SC5 may be greater than the size of a first electrode CEa3 of the third compensation capacitor SC3. In the specification, the sizes of the first electrode CEa and the second electrode CEb may mean the size of the first portion of each electrode. When the width Wa of the first electrode CEa in the first direction (e.g., the x direction) is the same, the length da3 of the first electrode CEa3 of the third compensation capacitor SC3 in the second direction (e.g., the y direction) may be greater than the length da1 of the first electrode CEa1 of the first compensation capacitor SC1 in the second direction. The length da5 of the first electrode CEa5 of the fifth compensation capacitor SC5 in the second direction may be greater than the length da3 of the first electrode CEa3 of the third compensation capacitor SC3 in the second direction.

Similarly, the first electrode CEa4 of the fourth compensation capacitor SC4 may be greater than the size of the first electrode CEa2 of the second compensation capacitor SC2. The size of the first electrode CEa6 of the sixth compensation capacitor SC6 may be greater than the size of the first electrode CEa4 of the fourth compensation capacitor SC4. When the width Wa of the first electrode CEa in the first direction (e.g., the x direction) is the same, the length da4 of the first electrode CEa4 of the fourth compensation capacitor SC4 in the second direction (e.g., the y direction) may be greater than the length da2 of the first electrode CEa2 of the second compensation capacitor SC2 in the second direction. The length da6 of the first electrode CEa6 of the sixth compensation capacitor SC6 in the second direction may be greater than the length da4 of the first electrode CEa4 of the fourth compensation capacitor SC4 in the second direction.

Referring to FIG. 7B, the size of a second electrode CEb3 of the third compensation capacitor SC3 may be greater than the size of a second electrode CEb1 of the first compensation capacitor SC1. The size of a second electrode CEb5 of the fifth compensation capacitor SC5 may be greater than the size of a second electrode CEb5 of the third compensation capacitor SC3. When the width Wb of the second electrode CEb in the first direction (e.g., the x direction) is the same, the length db3 of the second electrode CEb3 of the third compensation capacitor SC3 in the second direction (e.g., the y direction) may be greater than the length db1 of the first compensation capacitor SC1 in the second direction. The length db5 of the second electrode CEb5 of the fifth compensation capacitor SC5 in the second direction may be greater than the length db3 of the second electrode CEb5 of the third compensation capacitor SC3 in the second direction.

Similarly, the size of the second electrode CEb4 of the fourth compensation capacitor SC4 may be greater than the size of the second electrode CEb2 of the second compensation capacitor SC2. The size of the second electrode CEb6 of the sixth compensation capacitor SC6 may be greater than the size of the second electrode CEb4 of the fourth compensation capacitor SC4. When the width Wb of the second electrode CEb in the first direction (e.g., the x direction) is the same, the length db4 of the second electrode CEb4 of the fourth compensation capacitor SC4 in the second direction (e.g., the y direction) may be greater than the length db2 of the second electrode CEb2 of the second compensation capacitor SC2 in the second direction. The length db6 of the second electrode CEb6 of the sixth compensation capacitor SC6 in the second direction may be greater than the length db4 of the second electrode CEb4 of the fourth compensation capacitor SC4 in the second direction.

The second power supply line VL2 may overlap a fan-out line FWL and a compensation capacitor area SCA. A plurality of openings OP for outgassing may be defined in the second power supply line VL2. In an embodiment, the second power supply line VL2 may be electrically connected to the first power supply line VL1.

FIG. 8 is a schematic cross-sectional view of an embodiment of the display panel 10 of FIG. 6 taken along line B-B' shown in FIG. 3 and line D-D' of FIG. 6.

Referring to FIG. 8, the display panel 10 may include a substrate 100, an inorganic insulating layer 200, a sub-pixel circuit PC, a data line DL, a driving voltage line PL, a compensation capacitor SC, a first power supply line VL1, a second power supply line VL2, an organic insulating layer OIL, a light-emitting element layer 300, and an encapsulation layer 600 as a sealing structure The substrate 100 may include a display area DA and a non-display area NDA.

The inorganic insulating layer 200 may be disposed on the substrate 100. The inorganic insulating layer 200 may overlap the display area DA and the non-display area NDA. In an embodiment, the inorganic insulating layer 200 may include a buffer layer 211, a first inorganic insulating layer 213, a second inorganic insulating layer 215, and a third inorganic insulating layer 217. The buffer layer 211, the first inorganic insulating layer 213, the second inorganic insulating layer 215, and the third inorganic insulating layer 217 may be sequentially stacked on the substrate 100 in this stated order.

The sub-pixel circuit PC may include at least one transistor and at least one storage capacitor Cst. In an embodiment, the sub-pixel circuit PC may include a first transistor TFT1, a second transistor TFT2, and a storage capacitor Cst. The first transistor TFT1 may include a first semiconductor layer Act1, a first gate electrode GE1, a first source electrode SE1, and a first drain electrode DE1. The second transistor TFT2 may include a second semiconductor layer Act2, a second gate electrode GE2, a second source electrode SE2, and a second drain electrode DE2. The storage capacitor Cst may include a first capacitor electrode CE1 and a second capacitor electrode CE2.

The buffer layer 211 may be disposed on the substrate 100. The buffer layer 211 may include an inorganic insulating material, such as silicon nitride, silicon oxynitride, and silicon oxide, and may include a single layer or layers including the inorganic insulating material described above.

The first semiconductor layer Act1 and the second semiconductor layer Act2 may be disposed on the buffer layer 211. In an embodiment, the first semiconductor layer Act1 and the second semiconductor layer Act2 may be between the substrate 100 and the first inorganic insulating layer 213. The first semiconductor layer Act1 and the second semiconductor layer Act2 may overlap the display area DA in a plan view. At least one of the first semiconductor layer Act1 and the second semiconductor layer Act2 may include polysilicon. In an alternative embodiment, at least one of the first semiconductor layer Act1 and the second semiconductor layer Act2 may include amorphous silicon, an oxide semiconductor, or an organic semiconductor. In an embodiment, the first semiconductor layer Act1 and the second semiconductor layer Act2 may each include a channel region, and a source region and a drain region respectively on opposite sides of the channel region.

The first inorganic insulating layer 213 may be disposed on the buffer layer 211, the first semiconductor layer Act1, and the second semiconductor layer Act2. In an embodiment, the first inorganic insulating layer 213 may be a first gate insulating layer. The first inorganic insulating layer 213 may include an inorganic insulating material, such as silicon oxide, silicon nitride, silicon oxynitride, aluminum oxide, titanium oxide, tantalum oxide, hafnium oxide, or zinc oxide.

The first gate electrode GE1 and the second gate electrode GE2 may be disposed on the first inorganic insulating layer 213. In an embodiment, the first gate electrode GE1 and the second gate electrode GE2 may be between the first inorganic insulating layer 213 and the second inorganic insulating layer 215. The first gate electrode GE1 may overlap the first semiconductor layer Act1. In an embodiment, the first gate electrode GE1 may overlap the channel region of the first semiconductor layer Act1. The second gate electrode GE2 may overlap the second semiconductor layer Act2. In an embodiment, the second gate electrode GE2 may overlap the channel region of the second semiconductor layer Act2.

The first capacitor electrode CE1 may be disposed on the first inorganic insulating layer 213. The first capacitor electrode CE1 may be between the first inorganic insulating layer 213 and the second inorganic insulating layer 215. In an embodiment, the first capacitor electrode CE1 and the first gate electrode GE1 may be spaced apart from each other. In another embodiment, the first capacitor electrode CE1 may be integral with the first gate electrode GE1.

The first gate electrode GE1, the second gate electrode GE2, and the first capacitor electrode CE1 may be in the same layer and may include the same material. The first gate electrode GE1, the second gate electrode GE2, and the first capacitor electrode CE1 may each include a conductive material including molybdenum (Mo), aluminum (Al), copper (Cu), titanium (Ti), or the like, and may include a single layer or layers including the conductive material described above.

The second inorganic insulating layer 215 may be disposed on the first gate electrode GE1, the second gate electrode GE2, the first capacitor electrode CE1, and the first inorganic insulating layer 213. In an embodiment, the second inorganic insulating layer 215 may be a second gate insulating layer. The second inorganic insulating layer 215 may include an inorganic insulating material, such as silicon oxide, silicon nitride, silicon oxynitride, aluminum oxide, titanium oxide, tantalum oxide, hafnium oxide, or zinc oxide.

The second capacitor electrode CE2 may be disposed on the second inorganic insulating layer 215. The second capacitor electrode CE2 may overlap the first capacitor electrode CE1 in a plan view. The first capacitor electrode CE1 and the second capacitor electrode CE2 may constitute the storage capacitor Cst. The second capacitor electrode CE2 may include a conductive material including molybdenum (Mo), aluminum (Al), copper (Cu), titanium (Ti), or the like, and may include a single layer or layers including the conductive material described above.

The third inorganic insulating layer 217 may be disposed on the second capacitor electrode CE2 and the second inorganic insulating layer 215. In an embodiment, the third inorganic insulating layer 217 may be a first inter-insulating layer. The third inorganic insulating layer 217 may include an inorganic insulating material, such as silicon oxide, silicon nitride, silicon oxynitride, aluminum oxide, titanium oxide, tantalum oxide, hafnium oxide, or zinc oxide.

The first source electrode SE1, the first drain electrode DE1, the second source electrode SE2, the second drain electrode DE2, and the data line DL may be disposed on the third inorganic insulating layer 217. The first source electrode SE1 and the first drain electrode DE1 may be electrically connected to the first semiconductor layer Act1 through contact holes provided in insulating layers. The second source electrode SE2 and the second drain electrode DE2 may be electrically connected to the second semiconductor layer Act2 through contact holes provided in insulating layers. In an embodiment, the data line DL may be integral with the first source electrode SE1 or the second source electrode SE2.

In an embodiment, the first source electrode SE1, the first drain electrode DE1, the second source electrode SE2, the second drain electrode DE2, and the data line DL may be in the same layer and may include the same material. The first source electrode SE1, the first drain electrode DE1, the second source electrode SE2, the second drain electrode DE2, and the data line DL may each include a conductive material including molybdenum (Mo), aluminum (Al), copper (Cu), titanium (Ti), or the like, and may include a single layer or layers including the conductive material described above. In an embodiment, the first source electrode SE1, the first drain electrode DE1, the second source electrode SE2, the second drain electrode DE2, and the data line DL may each have a multilayer structure of Ti/Al/Ti.

The organic insulating layer OIL may be disposed on the inorganic insulating layer 200, the first source electrode SE1, the first drain electrode DE1, the second source electrode SE2, and the second drain electrode DE2. In an embodiment, the organic insulating layer OIL may include a first organic insulating layer OIL1 and a second organic insulating layer OIL2. The organic insulating layer OIL may include an organic material. The first organic insulating layer OIL1 and the second organic insulating layer OIL2 may each include an organic insulating material selected from general-purpose polymer, such as polymethylmethacrylate ("PMMA") or polystyrene ("PS"), polymer derivatives having a phenolic group, acrylic polymer, imide-based polymer, aryl ether-based polymer, amide-based polymer, fluorine-based polymer, p-xylene-based polymer, vinyl alcohol-based polymer, and any combinations thereof.

The driving voltage line PL may be between the first organic insulating layer OIL1 and the second organic insulating layer OIL2. The driving voltage line PL may include a conductive material including molybdenum (Mo), aluminum (Al), copper (Cu), titanium (Ti), or the like, and may include a single layer or layers including the conductive material described above.

The light-emitting element layer 300 may be disposed on the organic insulating layer OIL. The light-emitting element layer 300 may include a light-emitting element LED and a bank layer 340. In an embodiment, the light-emitting element LED may include an organic light-emitting diode. The light-emitting element LED may include a sub-pixel electrode 310, an emission layer 320, and an opposite electrode 330.

The sub-pixel electrode 310 may be disposed on the organic insulating layer OIL. The sub-pixel electrode 310 may be electrically connected to the sub-pixel circuit PC. In an embodiment, the organic insulating layer OIL may have a contact hole. The sub-pixel electrode 310 may be electrically connected to the sub-pixel circuit PC through the contact hole of the organic insulating layer OIL. In an embodiment, the sub-pixel electrode 310 may be electrically connected to the first source electrode SE1 or the first drain electrode DE1. The sub-pixel electrode 310 may include a conductive oxide, such as indium tin oxide ("ITO"), indium zinc oxide ("IZO"), zinc oxide (ZnO), indium oxide (In₂O₃), indium gallium oxide ("IGO"), or aluminum zinc oxide ("AZO"). In another embodiment, the sub-pixel electrode 310 may include a reflective layer including silver (Ag), magnesium (Mg), aluminum (Al), platinum (Pt), palladium (Pd), gold (Au), nickel (Ni), neodymium (Nd), iridium (Ir), chromium (Cr), or any combinations thereof. In another embodiment, the sub-pixel electrode 310 may further include a layer including ITO, IZO, ZnO, or In₂O₃ above and/or below the reflective layer.

A bank layer 340 defining an opening 340OP exposing the central portion of the sub-pixel electrode 310 may be disposed on the sub-pixel electrode 310. The bank layer 340 may include an organic insulating material and/or an inorganic insulating material. In some embodiments, the bank layer 340 may include a light-blocking material. The opening 340OP of the bank layer 340 may define an emission area of light emitted from the light-emitting element LED.

In an embodiment, the bank layer 340 may include a spacer SPC protruding in the thickness direction of the substrate 100. The spacer SPC may protrude from the bank layer 340 in the third direction (e.g., the z direction). The bank layer 340 including the spacer SPC may be formed by a halftone mask. In some embodiments, the spacer SPC may include a material that is different from a material of the bank layer 340 and may be disposed on the bank layer 340.

The emission layer 320 may be in the opening 340OP of the bank layer 340. The emission layer 320 may include a relatively high molecular weight organic material or a relatively low molecular weight organic material that emits light of a predetermined color. Although not illustrated, a first functional layer and a second functional layer may be disposed below and above the emission layer 320, respectively. In an embodiment, the first functional layer may include a hole transport layer ("HTL"), or may include an HTL and a hole injection layer ("HIL"). The second functional layer may be optionally disposed on the emission layer 320. The second functional layer may include an electron transport layer ("ETL") and/or an electron injection layer ("EIL"). The first functional layer and/or the second functional layer may be a common layer completely covering the substrate 100, like the opposite electrode 330 to be described below.

The opposite electrode 330 may be disposed on the emission layer 320. The opposite electrode 330 may include a conductive material having a relatively low work function. In an embodiment, the opposite electrode 330 may include a (semi)transparent layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), or any alloy thereof, for example. In an alternative embodiment, the opposite electrode 330 may further include a layer including ITO, IZO, ZnO, or In₂O₃ on the (semi)transparent layer including the material described above.

The non-display area NDA may be an area in which an image is not displayed. The inorganic insulating layer 200 may overlap the non-display area NDA in a plan view.

The compensation capacitor SC may be in the non-display area NDA. A plurality of compensation capacitors SC may be provided. The compensation capacitors SC may be arranged in the first direction (e.g., the x direction). The compensation capacitor SC may include a first electrode CEa and a second electrode CEb on the first electrode CEa.

In an embodiment, the first electrode CEa of the compensation capacitor SC may be between the first inorganic insulating layer 213 and the second inorganic insulating layer 215. The first electrode CEa of the compensation capacitor SC may include the same material as that of the first gate electrode GE1, the second gate electrode GE2, and the first capacitor electrode CE1 of the storage capacitor Cst. The first electrode CEa of the compensation capacitor SC may include a conductive material including molybdenum (Mo), aluminum (Al), copper (Cu), titanium (Ti), or the like, and may include a single layer or layers including the conductive material described above.

In an embodiment, the second electrode CEb of the compensation capacitor SC may be between the second inorganic insulating layer 215 and the third inorganic insulating layer 217. The second electrode CEb of the compensation capacitor SC may include the same material as that of the second capacitor electrode CE2 of the storage capacitor Cst. The second electrode CEb of the compensation capacitor SC may include a conductive material including molybdenum (Mo), aluminum (Al), copper (Cu), titanium (Ti), or the like, and may include a single layer or layers including the conductive material described above.

The first power supply line VL1 and the second power supply line VL2 may be in the non-display area NDA. The first power supply line VL1 may at least partially overlap the compensation capacitor SC. The first power supply line VL1 may be between the third inorganic insulating layer 217 and the first organic insulating layer OIL1. The first power supply line VL1 may include the same material as that of the first source electrode SE1, the first drain electrode DE1, the second source electrode SE2, the second drain electrode DE2, and the data line DL. The first power supply line VL1 may include a conductive material including molybdenum (Mo), aluminum (Al), copper (Cu), titanium (Ti), or the like, and may include a single layer or layers including the conductive material described above. In an embodiment, the first power supply line VL1 may have a multilayer structure of Ti/AI/Ti.

The second power supply line VL2 may be disposed on the first organic insulating layer OIL1, and the second organic insulating layer OIL2 may be disposed to cover the second power supply line VL2. The organic insulating layer OIL may be only in the display area and a portion of the non-display area NDA adjacent to the display area DA. In order to prevent formation of a moisture permeable path, the organic insulating layer OIL may be removed from most areas of the non-display area NDA.

The encapsulation layer 600 may be disposed on the light-emitting element layer 300. The encapsulation layer 600 may seal the light-emitting element LED. The encapsulation layer 600 may include at least one inorganic encapsulation layer and at least one organic encapsulation layer. The at least one inorganic encapsulation layer and the at least one organic encapsulation layer may be alternately stacked. In an embodiment, the encapsulation layer 600 may include a first inorganic encapsulation layer 610, an organic encapsulation layer 620, and a second inorganic encapsulation layer 630, which are sequentially stacked in this stated order. The first inorganic encapsulation layer 610 and the second inorganic encapsulation layer 630 may extend from the display area DA to the non-display area NDA. The first inorganic encapsulation layer 610 and the second inorganic encapsulation layer 630 may overlap the non-display area NDA in a plan view.

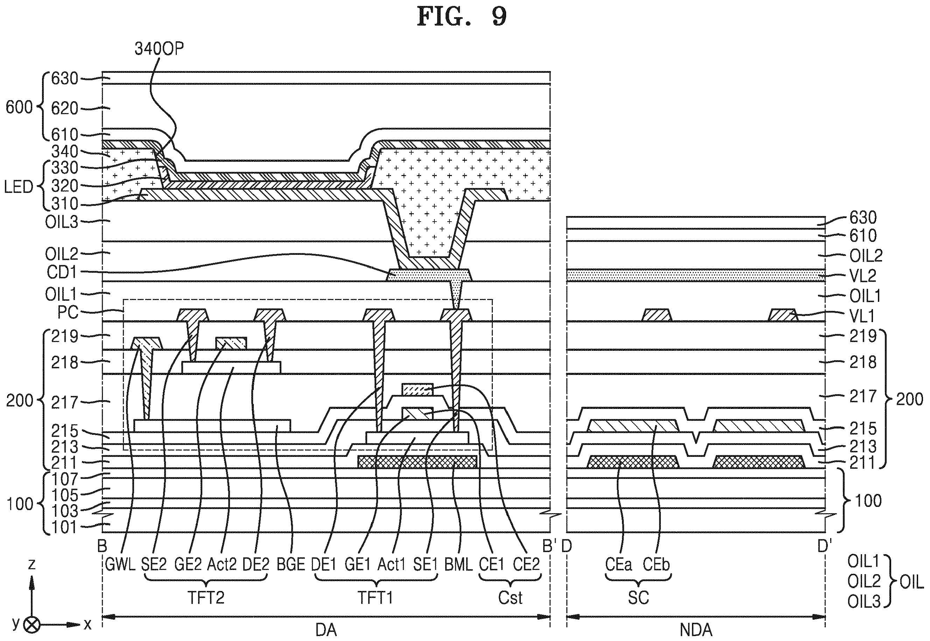

FIG. 9 is a cross-sectional view illustrating an embodiment of a portion of a display panel 10. FIG. 9 is a modification of FIG. 8. Hereinafter, differences will be mainly described and redundant descriptions will be omitted.

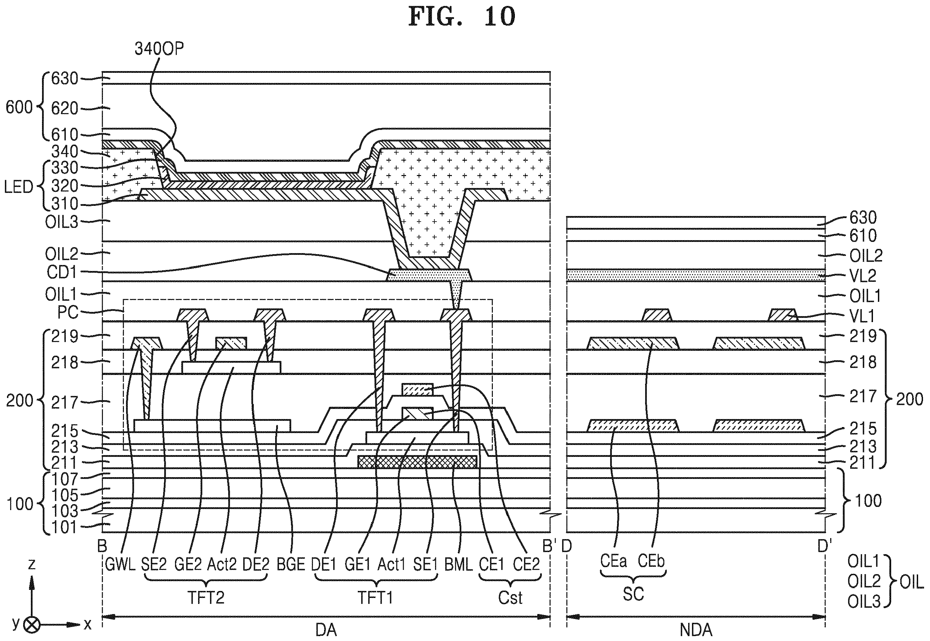

Referring to FIG. 10, the display panel 10 may include a substrate 100, an inorganic insulating layer 200, a sub-pixel circuit PC, a gate line GWL, a compensation capacitor SC, a first power supply line VL1, a second power supply line VL2, an organic insulating layer OIL, a light-emitting element layer 300, and an encapsulation layer 600 as a sealing structure. The substrate 100 may include a display area DA and a non-display area NDA.

The substrate 100 may include glass or polymer resin. In an embodiment, the substrate 100 may have a structure in which a base layer including polymer resin and a barrier layer including an inorganic insulating material, such as silicon oxide or silicon nitride, are alternately stacked. In an embodiment, the substrate 100 may include a first base layer 101, a first barrier layer 103, a second base layer 105, and a second barrier layer 107, which are sequentially stacked in this stated order, for example. The first base layer 101 and the second base layer 105 may each include polymer resin, and the first barrier layer 103 and the second barrier layer 107 may each include an inorganic insulating material.

The inorganic insulating layer 200 may be disposed on the substrate 100. The inorganic insulating layer 200 may overlap the display area DA and the non-display area NDA. In an embodiment, the inorganic insulating layer 200 may include a buffer layer 211, a first inorganic insulating layer 213, a second inorganic insulating layer 215, a third inorganic insulating layer 217, a fourth inorganic insulating layer 218, and a fifth inorganic insulating layer 219. The buffer layer 211, the first inorganic insulating layer 213, the second inorganic insulating layer 215, the third inorganic insulating layer 217, the fourth inorganic insulating layer 218, and the fifth inorganic insulating layer 219 may be sequentially stacked on the substrate 100 in this stated order.

A bottom metal layer BML may be between the substrate 100 and the buffer layer 211. In an alternative embodiment, the bottom metal layer BML may be between the first barrier layer 103 and the second barrier layer 107. The bottom metal layer BML may overlap at least one of a first semiconductor layer Act1 and a second semiconductor layer Act2 in a plan view. In some embodiments, a constant voltage or signal may be applied to the bottom metal layer BML. The bottom metal layer BML may include a conductive material including molybdenum (Mo), aluminum (Al), copper (Cu), titanium (Ti), or the like, and may include a single layer or layers including the conductive material described above. Because the bottom metal layer BML overlaps at least one of the first semiconductor layer Act1 and the second semiconductor layer Act2 in a plan view, characteristics of at least one of a first transistor TFT1 and a second transistor TFT2 may be improved.

In an embodiment, the sub-pixel circuit PC may include the first transistor TFT1, the second transistor TFT2, and a storage capacitor Cst. The first transistor TFT1 may include the first semiconductor layer Act1, a first gate electrode GE1, a first source electrode SE1, and a first drain electrode DE1. The second transistor TFT2 may include the second semiconductor layer Act2, a second gate electrode GE2, a second source electrode SE2, and a second drain electrode DE2. The storage capacitor Cst may include a first capacitor electrode CE1 and a second capacitor electrode CE2.

At least one of the first semiconductor layer Act1 and the second semiconductor layer Act2 may include an oxide semiconductor. In an embodiment, the first semiconductor layer Act1 may include a silicon semiconductor, and the second semiconductor layer Act2 may include an oxide semiconductor. The first semiconductor layer Act1 and the second semiconductor layer Act2 may each include a channel region, and a source region and a drain region respectively on opposite sides of the channel region.

The first semiconductor layer Act1 may be between the buffer layer 211 and the first inorganic insulating layer 213. In an embodiment, the first semiconductor layer Act1 may include a silicon semiconductor. In an embodiment, the first semiconductor layer Act1 may include polysilicon or amorphous silicon, for example.

The first gate electrode GE1 may be between the first inorganic insulating layer 213 and the second inorganic insulating layer 215. The first capacitor electrode CE1 may be between the first inorganic insulating layer 213 and the second inorganic insulating layer 215. In an embodiment, the first capacitor electrode CE1 may be integral with the first gate electrode GE1. The second capacitor electrode CE2 may be disposed on the second inorganic insulating layer 215. The second capacitor electrode CE2 may overlap the first gate electrode GE1 therebelow. The second capacitor electrode CE2 and the first gate electrode GE1 may overlap each other with the second inorganic insulating layer 215 therebetween to constitute the storage capacitor Cst.

The third inorganic insulating layer 217 may be disposed on the second capacitor electrode CE2 and the second inorganic insulating layer 215. The second semiconductor layer Act2 may be disposed on the third inorganic insulating layer 217. In an embodiment, the second semiconductor layer Act2 may include an oxide semiconductor. In an embodiment, the second semiconductor layer Act2 may include a Zn oxide-based material, such as Zn oxide, In-Zn oxide, or Ga-In-Zn oxide, for example. In an alternative embodiment, the second semiconductor layer Act2 may include In-Ga-Zn-O ("IGZO"), In-Sn-Zn-O ("ITZO"), or In-Ga-Sn-Zn-O ("IGTZO") semiconductor, in which a metal, such as indium (In), gallium (Ga), or tin (Sn), is included in ZnO.

The fourth inorganic insulating layer 218 may be disposed on the second semiconductor layer Act2 and the third inorganic insulating layer 217. In an embodiment, the fourth inorganic insulating layer 218 may be a third gate insulating layer. In an embodiment, the fourth inorganic insulating layer 218 may include an inorganic insulating material, such as silicon oxide, silicon nitride, silicon oxynitride, aluminum oxide, titanium oxide, tantalum oxide, hafnium oxide, or zinc oxide.

The second gate electrode GE2 may be disposed on the fourth inorganic insulating layer 218. The second gate electrode GE2 may be between the fourth inorganic insulating layer 218 and the fifth inorganic insulating layer 219. The second gate electrode GE2 may include a conductive material including molybdenum (Mo), aluminum (Al), copper (Cu), titanium (Ti), or the like, and may include a single layer or layers including the conductive material described above.

The first source electrode SE1, the first drain electrode DE1, the second source electrode SE2, and the second drain electrode DE2 may be disposed on the fifth inorganic insulating layer 219. In an embodiment, the fifth inorganic insulating layer 219 may be a second inter-insulating layer. In an embodiment, the fifth inorganic insulating layer 219 may include an inorganic insulating material, such as silicon oxide, silicon nitride, silicon oxynitride, aluminum oxide, titanium oxide, tantalum oxide, hafnium oxide, or zinc oxide. The first source electrode SE1 and the first drain electrode DE1 may be connected to the first semiconductor layer Act1 through contact holes of the insulating layers. The second source electrode SE2 and the second drain electrode DE2 may be electrically connected to the second semiconductor layer Act2 through contact holes of the insulating layers.

A bottom gate electrode BGE may be disposed below the second semiconductor layer Act2. In an embodiment, the bottom gate electrode BGE may be between the second inorganic insulating layer 215 and the third inorganic insulating layer 217. In an embodiment, the bottom gate electrode BGE may receive a gate signal. In this case, the second transistor TFT2 may have a double gate electrode structure in which gate electrodes are disposed above and below the second semiconductor layer Act2. The bottom gate electrode BGE may be in the same layer as the second capacitor electrode CE2 and may include the same material as that of the second capacitor electrode CE2.

The gate line GWL may be between the fourth inorganic insulating layer 218 and the fifth inorganic insulating layer 219. In an embodiment, the gate line GWL may be electrically connected to the bottom gate electrode BGE through contact holes provided in insulating layers. The gate line GWL may be in the same layer as the second gate electrode GE2 and may include the same material as that of the second gate electrode GE2. The gate line GWL may be integral with the second gate electrode GE2.

The organic insulating layer OIL may be disposed on the inorganic insulating layer 200, the first source electrode SE1, the first drain electrode DE1, the second source electrode SE2, and the second drain electrode DE2. In an embodiment, the organic insulating layer OIL may include a first organic insulating layer OIL1, a second organic insulating layer OIL2, and a third organic insulating layer OIL3.

A first connection electrode CD1 may be disposed on the first organic insulating layer OIL1. In this case, the first connection electrode CD1 may be connected to the first drain electrode DE1 or the first source electrode SE1 through the contact hole of the first organic insulating layer OIL1. The first connection electrode CD1 may include a conductive material including molybdenum (Mo), aluminum (Al), copper (Cu), titanium (Ti), or the like, and may include a single layer or layers including the conductive material described above.

The second organic insulating layer OIL2 and the third organic insulating layer OIL3 may be disposed to cover the first connection electrode CD1. The third organic insulating layer OIL3 may include an organic material. The third organic insulating layer OIL3 may include an organic insulating material selected from general-purpose polymer, such as PMMA or PS, polymer derivatives having a phenolic group, acrylic polymer, imide-based polymer, aryl ether-based polymer, amide-based polymer, fluorine-based polymer, p-xylene-based polymer, vinyl alcohol-based polymer, and any combinations thereof.

The light-emitting element layer 300 may be disposed on the organic insulating layer OIL. The light-emitting element layer 300 may include a light-emitting element LED and a bank layer 340. The light-emitting element LED may include a sub-pixel electrode 310, an emission layer 320, and an opposite electrode 330. The light-emitting element LED may be electrically connected to the sub-pixel circuit PC through the contact hole of the organic insulating layer OIL. In an embodiment, the sub-pixel electrode 310 of the light-emitting element LED may be electrically connected to the first connection electrode CD1 through the contact hole of the organic insulating layer OIL.

The compensation capacitor SC may be in the non-display area NDA. A plurality of compensation capacitors SC may be provided. The compensation capacitor SC may include a first electrode CEa and a second electrode CEb on the first electrode CEa.

In an embodiment, the first electrode CEa of the compensation capacitor SC may be between the buffer layer 211 and the first inorganic insulating layer 213. The first electrode CEa of the compensation capacitor SC may include the same material as that of the bottom metal layer BML. The first electrode CEa of the compensation capacitor SC may include a conductive material including molybdenum (Mo), aluminum (Al), copper (Cu), titanium (Ti), or the like, and may include a single layer or layers including the conductive material described above.

In an embodiment, the second electrode CEb of the compensation capacitor SC may be between the first inorganic insulating layer 213 and the second inorganic insulating layer 215. The second electrode CEb of the compensation capacitor SC may include the same material as that of the first gate electrode GE1 and the first capacitor electrode CE1 of the storage capacitor Cst. The second electrode CEb of the compensation capacitor SC may include a conductive material including molybdenum (Mo), aluminum (Al), copper (Cu), titanium (Ti), or the like, and may include a single layer or layers including the conductive material described above.

FIG. 10 is a cross-sectional view illustrating an embodiment of a portion of a display panel. FIG. 10 is a modification of FIG. 9 and differs from FIG. 9 in view of a structure of a compensation capacitor SC. Hereinafter, differences between the compensation capacitors SC are mainly described.

Referring to FIG. 10, the compensation capacitor SC may be in a non-display area NDA. A plurality of compensation capacitors SC may be provided. The compensation capacitor SC may include a first electrode CEa and a second electrode CEb on the first electrode CEa.

In an embodiment, the first electrode CEa of the compensation capacitor SC may be between a second inorganic insulating layer 215 and a third inorganic insulating layer 217. The first electrode CEa of the compensation capacitor SC may include the same material as that of a second capacitor electrode CE2 of a storage capacitor Cst and a bottom gate electrode BGE. The first electrode CEa of the compensation capacitor SC may include a conductive material including molybdenum (Mo), aluminum (Al), copper (Cu), titanium (Ti), or the like, and may include a single layer or layers including the conductive material described above.

In an embodiment, the second electrode CEb of the compensation capacitor SC may be between a fourth inorganic insulating layer 218 and a fifth inorganic insulating layer 219. The second electrode CEb of the compensation capacitor SC may include the same material as that of a second gate electrode GE2. The second electrode CEb of the compensation capacitor SC may include a conductive material including molybdenum (Mo), aluminum (Al), copper (Cu), titanium (Ti), or the like, and may include a single layer or layers including the conductive material described above.

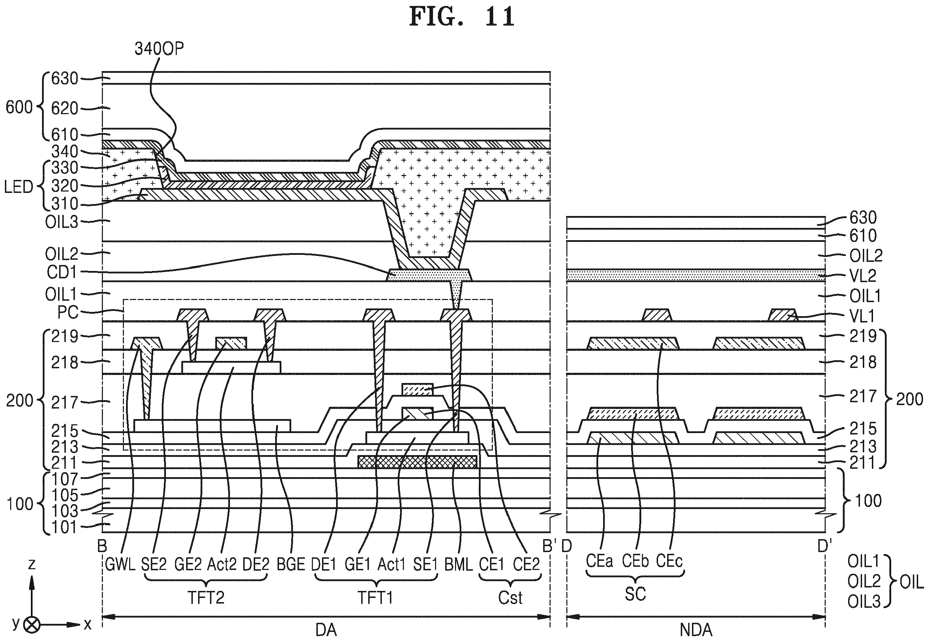

FIG. 11 is a cross-sectional view illustrating an embodiment of a portion of a display panel. FIG. 11 is a modification of FIG. 9 and differs from FIG. 9 in view of a structure of a compensation capacitor SC. Hereinafter, differences between the compensation capacitors SC are mainly described.

Referring to FIG. 11, the compensation capacitor SC may be in a non-display area NDA. A plurality of compensation capacitors SC may be provided. The compensation capacitor SC may include a first electrode CEa, a second electrode CEb on the first electrode CEa, and a third electrode CEc on the second electrode CEb. The third electrode CEc of the compensation capacitor SC may be electrically connected to the first electrode CEa.

In an embodiment, the first electrode CEa of the compensation capacitor SC may be between a first inorganic insulating layer 213 and a second inorganic insulating layer 215. The first electrode CEa of the compensation capacitor SC may include the same material as that of a first gate electrode GE1 and a first capacitor electrode CE1 of a storage capacitor Cst. The first electrode CEa of the compensation capacitor SC may include a conductive material including molybdenum (Mo), aluminum (Al), copper (Cu), titanium (Ti), or the like, and may include a single layer or layers including the conductive material described above.

In an embodiment, the second electrode CEb of the compensation capacitor SC may be between the second inorganic insulating layer 215 and a third inorganic insulating layer 217. The second electrode CEb of the compensation capacitor SC may include the same material as that of a second capacitor electrode CE2 of the storage capacitor Cst and a bottom gate electrode BGE. The second electrode CEb of the compensation capacitor SC may include a conductive material including molybdenum (Mo), aluminum (Al), copper (Cu), titanium (Ti), or the like, and may include a single layer or layers including the conductive material described above.

In an embodiment, the third electrode CEc of the compensation capacitor SC may be between a fourth inorganic insulating layer 218 and a fifth inorganic insulating layer 219. The third electrode CEc of the compensation capacitor SC may include the same material as that of a second gate electrode GE2. The third electrode CEc of the compensation capacitor SC may include a conductive material including molybdenum (Mo), aluminum (Al), copper (Cu), titanium (Ti), or the like, and may include a single layer or layers including the conductive material described above.

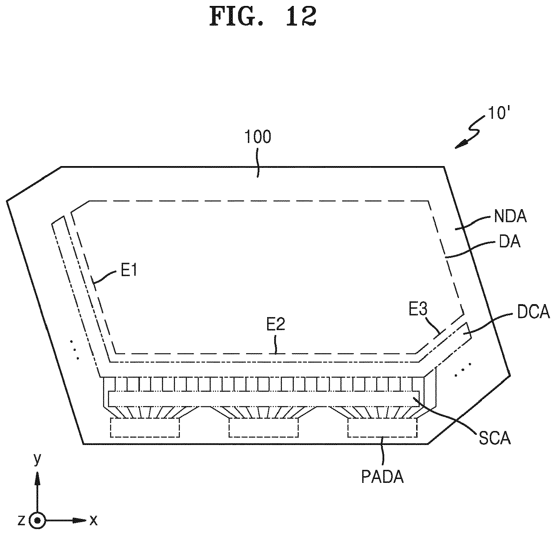

FIG. 12 is a plan view illustrating an embodiment of a display panel 10'. FIG. 12 is a modification of FIG. 3 and differs from FIG. 3 in view of the planar structure of the display panel. Hereinafter, differences are mainly described.

Referring to FIG. 12, the display panel 10' may include a substrate 100, a fan-out line FWL, a compensation capacitor, and a demultiplexer circuit. The substrate 100 may include a display area DA and a non-display area NDA. The display area DA may be an area in which an image is displayed. The non-display area NDA may surround the display area DA. The non-display area NDA may be an area in which an image is not displayed.

Although FIG. 3 illustrates that the substrate 100 and the display area DA each have a quadrangular shape, e.g., rectangular shape, embodiments of the disclosure are not limited thereto. The substrate 100 and the display area DA of the display panel 10' may each have various shapes, e.g., a circular shape, an elliptical shape, or a polygonal shape, such as a triangular or a pentagonal shape. In an alternative embodiment, edges constituting the shape of the substrate 100 and the display area DA of the display panel 10' may extend in different directions from each other. In an embodiment, FIG. 12 illustrates that the substrate 100 and the display area DA of the display panel 10' each have a hexagonal shape.

The non-display area NDA may include a pad area PADA. The pad area PADA may be outside the display area DA. In an embodiment, a plurality of pad areas PADA may be provided.

The non-display area NDA may include a demultiplexer circuit area DCA. The demultiplexer circuit area DCA may be arranged adjacent to the display area DA. A plurality of demultiplexer circuits may be in the demultiplexer circuit area DCA. In an embodiment, the demultiplexer circuit area DCA may extend to correspond to the shape of the display area DA. That is, the demultiplexer circuits may be arranged along the edge of the display area DA. In an embodiment, the demultiplexer circuit area DCA may be arranged along first to third edges E1, E2, and E3 of the display area DA, for example. In this case, the first to third edges E1, E2, and E3 of the display area DA may extend in different directions from each other. The second edge E2 may extend in the first direction (e.g., the x direction), the first and third edges E1 and E3 may extend in different directions crossing the first direction (e.g., the x direction) and the second direction (e.g., the y direction).

The fan-out line FWL may extend in a direction from the pad area PADA to the display area DA. A plurality of fan-out lines FWL may be provided. The fan-out line FWL may extend from the pad areas PADA to the display area DA. In an embodiment, the fan-out lines FWL may extend from the pad area PADA toward the first edge E1 or the third edge E3 as well as the second edge E2 of the display area DA.

The compensation capacitor area SCA may be between the pad area PADA and the demultiplexer circuit area DCA. The compensation capacitor area SCA may be arranged adjacent to the demultiplexer circuit area DCA. The compensation capacitor area SCA may include a plurality of compensation capacitors. In an embodiment, the compensation capacitor area SCA may extend to correspond to the shape of the display area DA. That is, the compensation capacitors may be arranged along the edge of the display area DA. In an embodiment, FIG. 12 illustrates that the compensation capacitor area SCA extends in the first direction (e.g., the x direction) so as to correspond to the second edge E2, for example. However, embodiments of the disclosure are not limited thereto. In another embodiment, the compensation capacitor area SCA may be arranged along the first edge E1, the second edge E2, and/or the third edge E3 of the display area DA.

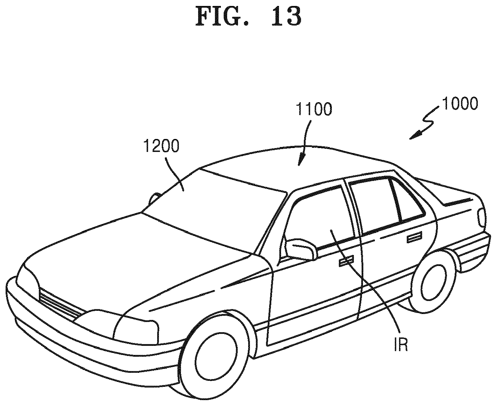

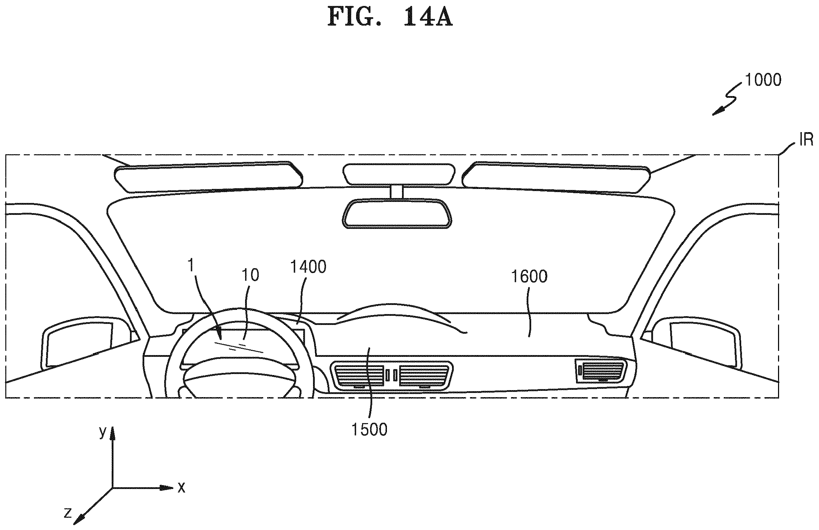

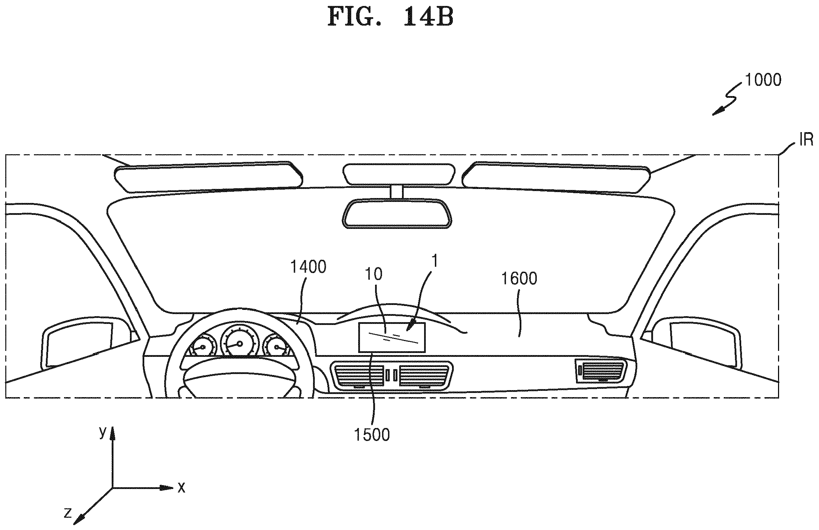

FIG. 13 is a diagram schematically illustrating an embodiment of the exterior of a vehicle 1000, and FIGS. 14A and 14B are respectively diagrams schematically illustrating the interior of the vehicle 1000 according to various embodiments.

Referring to FIGS. 13, 14A, and 14B, the vehicle 1000 may refer to various devices that move objects, such as humans, things, or animals, from a starting point to a destination. The vehicle 1000 may include a vehicle that travels on a road or a track, a ship that moves over the sea or river, and an airplane that flies in the sky by the action of air. The vehicle 1000 may travel on a road or a track. The vehicle 1000 may move in a predetermined direction according to rotation of at least one wheel. In an embodiment, the vehicle 1000 may include a three- or four-wheeled vehicle, a construction machine, a two-wheeled vehicle, a motor vehicle, a bicycle, and a train running on a track, for example.

In an embodiment, the vehicle 1000 may include a vehicle body 1100 and a display apparatus 1. The vehicle body 1100 may form the exterior of the vehicle 1000 and may define an interior space IR of the vehicle 1000 in which a driver and passengers ride. The vehicle body 1100 may include a front window 1200 that protects the driver and passengers from the outside and provides a front field of view to the driver.

The display apparatus 1 may include a display panel 10, and the display panel 10 may display an image. The display apparatus 1 may be in the interior space IR of the vehicle 1000. The vehicle 1000 may include a cluster 1400 provided in the interior space IR, a center fascia 1500, and a passenger seat dashboard 1600.

The cluster 1400 may be disposed in front of a steering wheel. A tachometer, a speedometer, a coolant temperature gauge, a fuel gauge turn indicator, a relatively high beam indicator, a warning lamp, a seat belt warning lamp, an odometer, an odometer, an automatic shift selection lever indicator, a door open warning lamp, an engine oil warning lamp, and/or a relatively low fuel warning lamp may be in the cluster 1400.

The center fascia 1500 may include a control panel on which a plurality of buttons for controlling an audio device, an air conditioner, and a seat heater are arranged. The center fascia 1500 may be on one side of the cluster 1400.

The passenger seat dashboard 1600 may be spaced apart from the cluster 1400 with the center fascia 1500 therebetween. In an embodiment, the cluster 1400 may be disposed to correspond to the driver seat, and the passenger seat dashboard 1600 may be disposed to correspond to the passenger seat.

In an embodiment, the display apparatus 1 may be on at least one of the cluster 1400, the center fascia 1500, and the passenger seat dashboard 1600.

Referring to FIG. 14A, the display apparatus 1 may be on the cluster 1400. In this case, the cluster 1400 may display driving information or the like on the display apparatus 1. That is, the cluster 1400 may be implemented as a digital cluster. The digital cluster 1400 may display vehicle information and traveling information as images. In an embodiment, needles and gauges of the tachometer and various warning lamp icons may be displayed by digital signals, for example.

Referring to FIG. 14B, the display apparatus 1 may be on the center fascia 1500. In an embodiment, the display apparatus 1 may display navigation information. In an embodiment, the display apparatus 1 may display information about audio, video, or vehicle settings.

Also, although not illustrated, the display apparatus 1 may be on the passenger seat dashboard 1600. The display apparatus 1 may be embedded in the passenger seat dashboard 1600 or may be on the passenger seat dashboard 1600. In an embodiment, the display apparatus 1 on the passenger seat dashboard 1600 may display an image related to information displayed on the cluster 1400 and/or information displayed on the center fascia 1500. In another embodiment, the display apparatus 1 on the passenger seat dashboard 1600 may display information that is different from information displayed on the cluster 1400 and/or information displayed on the center fascia 1500.

As discussed, embodiments can provide a display panel comprising: a substrate comprising: a display area including a sub-pixel; and a non-display area outside the display area, the non-display area including a pad area; a demultiplexer circuit area which is disposed in the non-display area and is arranged to transmit a data signal to the sub-pixel; a compensation capacitor area between the pad area and the demultiplexer circuit area, the compensation capacitor area comprising: a plurality of compensation capacitors each comprising: a first electrode; and a second electrode on the first electrode; and a plurality of fan-out lines extending from the pad area to the compensation capacitor area.

The first electrode is electrically connected to one of the plurality of fan-out lines, and the second electrode may electrically connected to a power supply line. The second electrode may overlap the first electrode with an insulating layer therebetween.

The display panel may comprise a light-emitting element in the display area; a first transistor between the substrate and the light-emitting element; and a storage capacitor electrically connected to the first transistor, wherein the first transistor comprises a first semiconductor layer and a first gate electrode overlapping a channel region of the first semiconductor layer, and the storage capacitor comprises a first capacitor electrode in a same layer as the first gate electrode and a second capacitor electrode on the first capacitor electrode.

The second capacitor electrode may overlaps the first capacitor electrode, with an insulating layer therebetween. This may be the same insulating layer as that of the compensation capacitors.

Embodiments can provide a vehicle comprising: a vehicle body defining an interior space; and a display panel in the interior space, the display panel being according to any of the above described embodiments.

As described above, embodiments may include a compensation capacitor area between the pad area and the demultiplexer circuit area. Accordingly, the display quality and reliability of the display panel may be improved. The scope of the disclosure is not limited by such an effect.

It should be understood that embodiments described herein should be considered in a descriptive sense only and not for purposes of limitation. Descriptions of features or advantages within each embodiment should typically be considered as available for other similar features or advantages in other embodiments. While embodiments have been described with reference to the drawing figures, it will be understood by those of ordinary skill in the art that various changes in form and details may be made therein without departing from the scope as defined by the following claims.

## Claims

1. A display panel comprising:
a substrate comprising:
a display area including a sub-pixel; and
a non-display area outside the display area, the non-display area including a pad area;
a demultiplexer circuit area which is disposed in the non-display area and is arranged to transmit a data signal to the sub-pixel;
a compensation capacitor area between the pad area and the demultiplexer circuit area, the compensation capacitor area comprising:
a plurality of compensation capacitors each comprising:
a first electrode; and
a second electrode on the first electrode; and
a plurality of fan-out lines extending from the pad area to the compensation capacitor area.

2. The display panel of claim 1, wherein the first electrode is electrically connected to one of the plurality of fan-out lines, and
the second electrode is electrically connected to a power supply line.

3. The display panel of claim 2, wherein the second electrode overlaps the first electrode, with an insulating layer therebetween.

4. The display panel of any one of claims 1 to 3, wherein the plurality of fan-out lines is arranged in a direction away from a central portion of the pad area and comprises a first fan-out line and a second fan-out line in a same layer, and
a length of the second fan-out line is greater than a length of the first fan-out line.

5. The display panel of claim 4, wherein the plurality of compensation capacitors comprises a first compensation capacitor electrically connected to the first fan-out line and a second compensation capacitor electrically connected to the second fan-out line, and
a capacitance of the first compensation capacitor is greater than a capacitance of the second compensation capacitor.

6. The display panel of claim 5, wherein an area of the first electrode of the first compensation capacitor is greater than an area of the first electrode of the second compensation capacitor, and
an area of the second electrode of the first compensation capacitor is greater than an area of the second electrode of the second compensation capacitor.

7. The display panel of any one of claims 1 to 6, further comprising:
a light-emitting element in the display area;
a first transistor between the substrate and the light-emitting element; and
a storage capacitor electrically connected to the first transistor,
wherein the first transistor comprises a first semiconductor layer and a first gate electrode overlapping a channel region of the first semiconductor layer, and
the storage capacitor comprises a first capacitor electrode in a same layer as the first gate electrode and a second capacitor electrode on the first capacitor electrode.

8. The display panel of claim 7, wherein the second capacitor electrode overlaps the first capacitor electrode, with an insulating layer therebetween.

9. The display panel of claim 7 or 8 , wherein the first electrode includes a same material as a material of the first gate electrode, and
the second electrode includes a same material as a material of the second capacitor electrode.

10. The display panel of claim 9, wherein the insulating layer of the storage capacitor is in a same layer as the insulating layer of the compensation capacitors.

11. The display panel of any one of claims 7 to 10, further comprising:
a second transistor on the substrate; and
a bottom metal layer below the first semiconductor layer,
wherein the second transistor comprises a second semiconductor layer including an oxide semiconductor, and a second gate electrode on the second semiconductor layer and overlapping a channel region of the second semiconductor layer.

12. The display panel of claim 11, wherein the first electrode includes a same material as a material of the bottom metal layer, and the second electrode includes a same material as a material of the first gate electrode; or
wherein the first electrode includes a same material as a material of the second capacitor electrode, and the second electrode includes a same material as a material of the second gate electrode.

13. The display panel of claim 11, wherein the plurality of compensation capacitors each further comprises a third electrode on the second electrode and electrically connected to the first electrode,
the first electrode includes a same material as a material of the first gate electrode, and
the second electrode includes a same material as a material of the second capacitor electrode, and
the third electrode includes a same material as a material of the second gate electrode.

14. A vehicle comprising:
a vehicle body defining an interior space; and
a display panel in the interior space, the display panel being according to any one of claims 1 to 13.

15. The vehicle of claim 14, further comprising:
a cluster;
a center fascia; and
a passenger seat dashboard spaced apart from the cluster with the center fascia therebetween,
wherein the display panel is on at least one of the cluster, the center fascia, or the passenger seat dashboard.
